# EUROPEAN PATENT APPLICATION

(11) **EP 4 580 041 A1**
(43) Date of publication of application: **02.07.2025**
(21) Application number: 23856880.2
(22) Date of filing: 24.03.2023
(51) Int. Cl.: H02S 30/00, H01L 31/049, H02S 20/10

(54) **LAMINATED BODY AND SOLAR POWER GENERATION SYSTEM**

(30) Priority: 22.08.2022 JP 2022131683; 31.08.2022 JP 2022137704; 22.09.2022 JP 2022151702
(71) Applicant: SEKISUI CHEMICAL CO., LTD., Osaka-shi Osaka 530-8565 (JP)
(72) Inventor: MATSUSHIMA, Kazushi, Osaka-shi, Osaka 530-8565 (JP); HISATA, Shinichi, Osaka-shi, Osaka 530-8565 (JP); TSUJIMURA, Shou, Osaka-shi, Osaka 530-8565 (JP); YOKOTA, Ibuki, Osaka-shi, Osaka 530-8565 (JP); UNO, Tomohito, Osaka-shi, Osaka 530-8565 (JP)
(74) Representative: Ter Meer Steinmeister & Partner
(86) International application number: PCT/JP2023/011955
(87) International publication number: WO 2024/042759

(57) **Abstract**

Provided is a laminated body that includes an installation surface and a back sheet constituting a bottom section of a solar power generation device and in which a gap is unlikely to occur between the installation surface and the back sheet. A laminated body 1 of the present invention includes an installation surface 3, an elastic body 4, and a back sheet 6 constituting a bottom section of a solar power generation device 5. The elastic body 4 is fixed in a state placed on the installation surface 3. The back sheet 6 is fixed in a state placed on an upper surface of the elastic body 4.

## Description

### Technical Field

The present invention relates to a laminated body that includes an installation surface and a back sheet constituting a bottom section of a solar power generation device, and relates to a solar power generation system that includes an installation surface and a solar power generation device.

### Background Art

In recent years, a fiber-containing sheet 400 is placed on the ground 2 and a solar power generation device 401 is placed on the upper surface of the fiber-containing sheet 400 as shown in Figs. 1 and 2. Patent Literature 1 discloses using non-woven fabric for weed prevention as the above-mentioned fiber-containing sheet 400. Patent Literature 2 discloses that a solar battery laminated body 100 is used by sticking it to a paved road 1 by means of an adhesive layer 5.

### Citation List

### Patent Literature

PTL 1: Japanese Utility Model Registration No. 3232136
PTL 2: JP 2013-38228A

### Summary of Invention

### Technical Problem

The above-mentioned conventional fiber-containing sheet 400 and the installation surface such as the paved road 1 are generally reinforced with fibers or paved with asphalt or the like, and thus have a low linear expansion coefficient. On the other hand, the solar battery laminated body 100 and the back sheet 402 constituting the bottom section of the solar power generation device 401 are not commonly reinforced with fibers or the like and have a high linear expansion coefficient for the purpose of, for example, ensuring the flexibility of the solar power generation device. Thus, thermal expansion/contraction occurring in the back sheet 402 of the solar power generation device 401 and the solar battery laminated body 100 is different from that of the installation surface (the fiber-containing sheet 400 or the paved road 1) due to temperature changes.

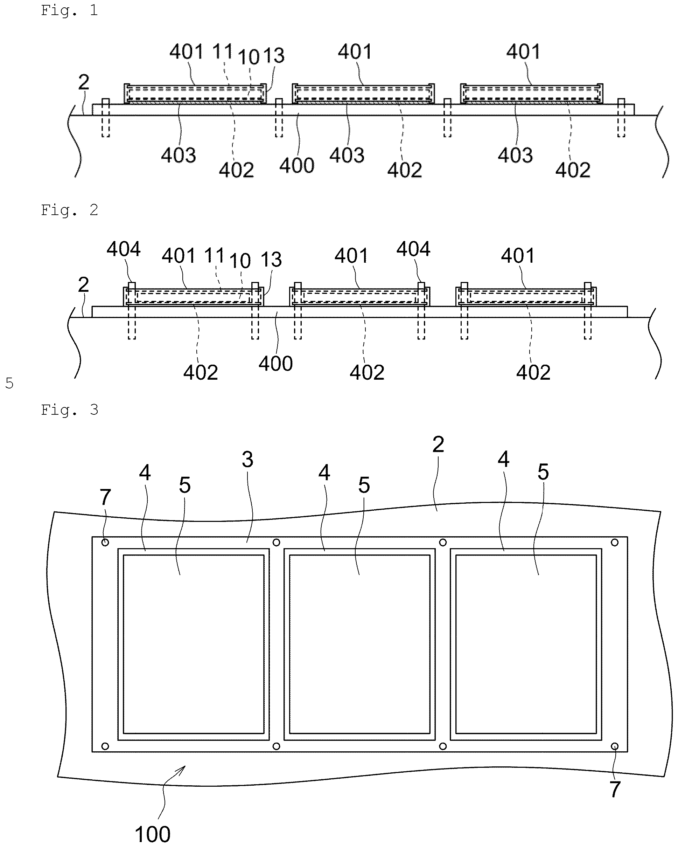

As shown in Fig. 1, when the fiber-containing sheet 400 and the back sheet 402 of the solar power generation device 401 are adhered with an adhesive 403, large shear stress occurs between the fiber-containing sheet 400 and the back sheet 402 due to the above-mentioned difference in thermal expansion/contraction. This causes the back sheet 402 to delaminate from the fiber-containing sheet 400 and results in a gap between the fiber-containing sheet 400 and the back sheet 402, making it difficult to fix the solar power generation device 401 stably for a long period of time. This phenomenon may also occur similarly when the solar power generation device 401 is installed on an installation surface consisting of asphalt, metal, hard resin, ceramics, or the like.

In addition, when the solar power generation device 401 and the fiber-containing sheet 400 are partially fixed using a fixing means such as a pile 404 that extends through the solar power generation device 401 and the fiber-containing sheet 400 as shown in FIG. 2, wind may enter a gap occurring between the fiber-containing sheet 400 and the back sheet 402 to vibrate the solar power generation device 401, resulting in a decrease in the power generation efficiency of the solar power generation device 401 and damage to power generation cells and wiring.

Furthermore, with recent technological progress, the increase in the size of solar power generation devices is being considered due to their light weight. The larger the conventional rigid solar power generation devices are, the less constructable, workable, and portable they are due to their weight. There is therefore a need to increase the size of flexible solar power generation devices. However, when increasing the size of flexible solar power generation devices is increased, thermal expansion/contraction will cause greater deformation of the entire sheet than when increasing the size of rigid solar power generation devices. Such deformation caused by thermal expansion/contraction is particularly significant in the back sheet where flexible resin materials are mainly used.

The present invention has been made in view of the above issues, and its object is to provide a laminated body that includes an installation surface and a back sheet constituting a bottom section of a solar power generation device, and in which a gap is unlikely to occur between the installation surface and the back sheet.

Another object of the present is to provide a solar power generation system that includes an installation surface and a solar power generation device with a bottom section constituted by a back sheet, and in which a gap is unlikely to occur between the installation surface and the back sheet.

### Solution to Problem

To achieve the above objects, the present invention includes the subject matter stated in the following items.

Item 1. A laminated body including:
an installation surface;
an elastic body; and
a back sheet constituting a bottom section of a solar power generation device,
the elastic body being fixed in a state placed on the installation surface, and
the back sheet being fixed in a state placed on an upper surface of the elastic body.

Item 2. The laminated body according to item 1, wherein the elastic body has a longitudinal elastic modulus of 0.1 MPa or greater and 1000 MPa or less.

Item 3. The laminated body according to item 1, wherein a ratio (Eb/Ea) between a transverse elastic modulus Ea of the back sheet and a transverse elastic modulus Eb of the elastic body is 0.002 or greater and 0.05 or less.

Item 4. The laminated body according to item 1, wherein the elastic body has a transverse elastic modulus of 0.1 MPa or greater and 100 MPa or less.

Item 5. The laminated body according to any one of items 1 to 4,
wherein the installation surface is constituted by a fiber-containing sheet, and
a shear peel strength of the fiber-containing sheet and the back sheet through the elastic body is 0.1 N/cm or greater.

Item 6. The laminated body according to any one of items 1 to 5,
wherein the installation surface is constituted by a fiber-containing sheet, and
the elastic body has a linear expansion coefficient that is greater than a linear expansion coefficient of the fiber-containing sheet and smaller than a linear expansion coefficient of the back sheet.

Item 7. The laminated body according to any one of items 1 to 6,
wherein the solar power generation device includes: the back sheet; a power generation unit; a barrier sheet; and a sealant,
the barrier sheet is located on an opposite side to the back sheet in a thickness direction of the solar power generation device,
the power generation unit includes a power generation cell being a photoelectric conversion element utilizing a photovoltaic effect, and is located between the back sheet and the barrier sheet,
the sealant fills a space surrounding the power generation unit between the barrier seat and the back sheet, and
the sealant has a transverse elastic modulus of 0.01 MPa or greater and 500 MPa or less.

Item 8. A solar power generation system including:
an installation surface;
an elastic body; and
a solar power generation device,
the elastic body being fixed in a state placed on the installation surface, and a back sheet constituting a bottom section of the solar power generation device being fixed in a state placed on an upper surface of the elastic body.

### Advantageous Effects of Invention

According to the laminated body and the solar power generation system of the present invention, a gap is unlikely to occur between the installation surface and the back sheet constituting the bottom section of the solar power generation device.

### Brief Description of Drawings

Fig. 1 is a side view of a conventional solar power generation system.
Fig. 2 is a side view of a conventional solar power generation system.
Fig. 3 is a plan view of a solar power generation system that includes a laminated body according to an embodiment of the present invention.
Fig. 4 is a side view of the solar power generation system that includes the laminated body according to the embodiment of the present invention.
Fig. 5(A) is a cross-sectional view of a solar power generation device. Fig. 5(B) is an enlarged view of an area a in Fig. 5(A). Fig. 5(C) is a cross-sectional view of a power generation unit taken along a line A-A in Fig. 5(A).
Fig. 6 is a side view of a solar power generation system according to a variation of the present invention.
Fig. 7 is a side view of a solar power generation system according to a variation of the present invention.
Fig. 8 is a cross-sectional view of a solar power generation system according to a variation of the present invention.
Fig. 9 is an exploded perspective view of the solar power generation system shown in Fig. 8.
Fig. 10(A) is an enlarged view of an area corresponding to an area A in Fig. 8. Fig. 10(B) is an enlarged view of an area B in Fig. 10(A).
Fig. 11(A) is a cross-sectional view showing a state where a sealant, a power generation layer, and a barrier sheet are attached to a building board. Fig. 11(B) is a cross-sectional view of a solar power generation system according to a variation.
Fig.12 is a plan view of a solar power generation system according to a variation of the present invention.
Fig. 13 is a cross-sectional view taken along a line a-a in Fig. 12.
Fig. 14 is a plan view of a solar power generation system according to a variation of the present invention.
Fig. 15 is a cross-sectional view taken along a line a-a in Fig. 14.
Fig. 16(A) is a cross-sectional view of a fixing tool, and Fig. 16(B) is an enlarged view of an area C in Fig. 16 (A).
Fig. 17(A) is a cross-sectional view of the fixing tool, and Fig. 17(B) is an enlarged view of an area D in Fig. 17(A).
Fig. 18 is a plan view of a solar power generation system according to a variation of the present invention.
Fig. 19 is a schematic cross-sectional view taken along a line a-a in Fig. 18.
Figs. 20(A) to 20(G) are cross-sectional views of the fixing tool.
Figs. 21(A) to 21(F) show the fixing tool, where upper figures in Figs. 21(A) to 21(F) are plan views of the fixing tool, and lower figures in Figs. 21(A) to 21(F) are cross-sectional views of the fixing tool.
Fig. 22 is a perspective view of a portion of a solar power generation system according to a variation of the present invention.
Fig. 23(A) is a cross-sectional view taken along a line a-a in Fig. 22, and Fig. 23(B) is a cross-sectional view taken along a line b-b in Fig. 22.

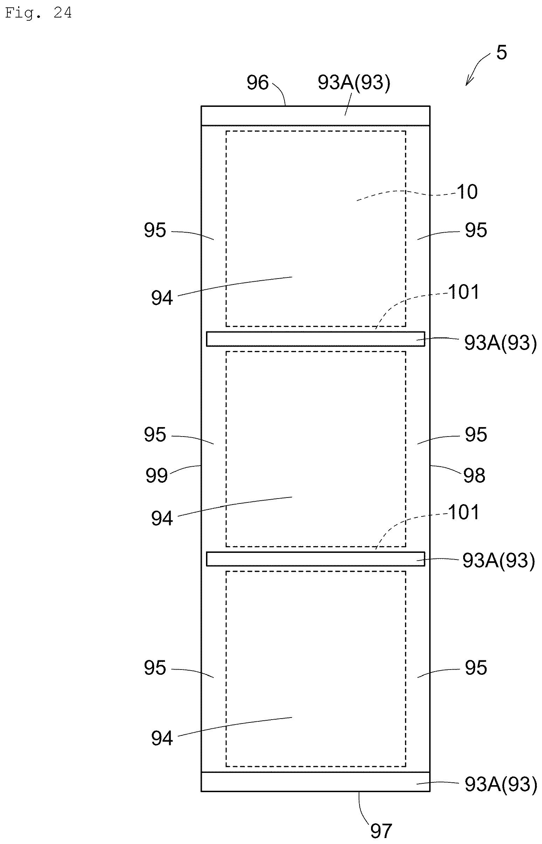

Fig. 24 is a bottom view of a solar power generation device.
Fig. 25 show cross-sectional views illustrating a procedure for peeling off a solar power generation device from an installation surface in a solar power generation system according to a variation of the present invention.

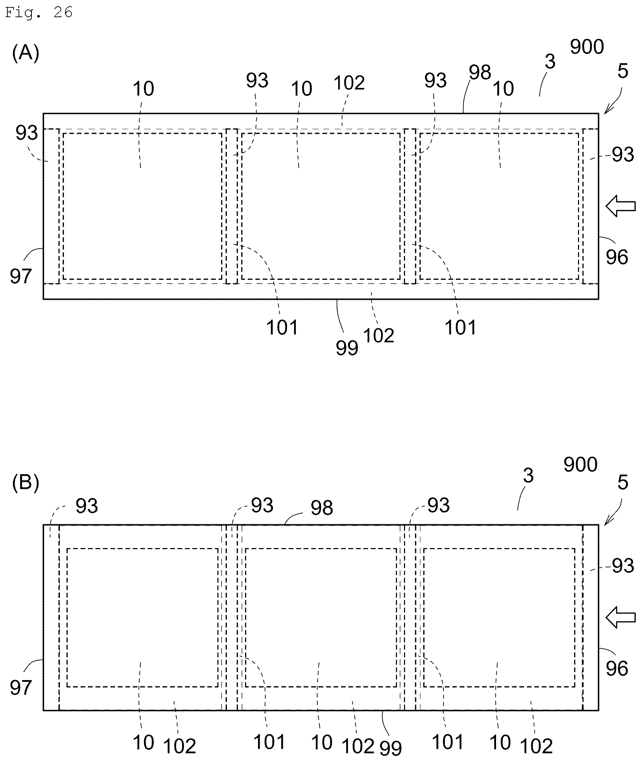

Fig. 26 show plan views of a solar power generation system according to a variation of the present invention.

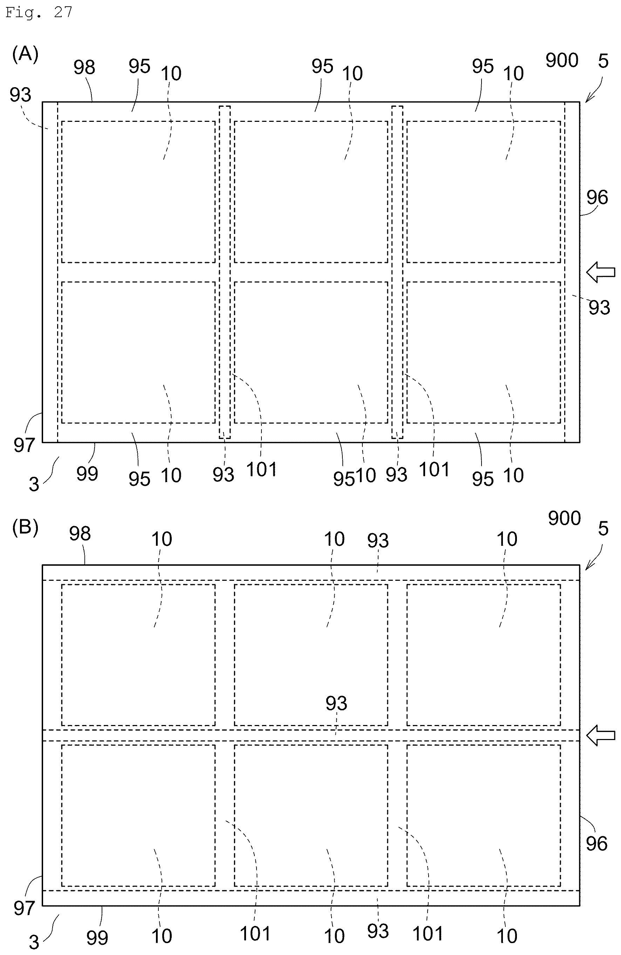

Fig. 27 show plan views of a solar power generation system according to a variation of the present invention.

### Description of Embodiments

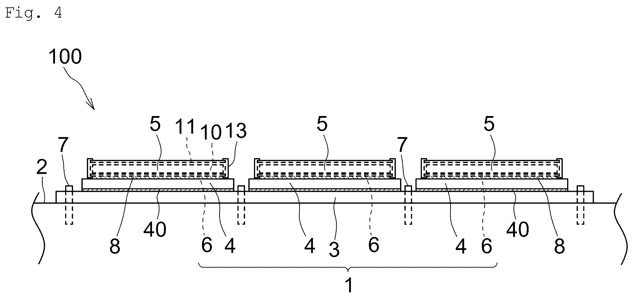

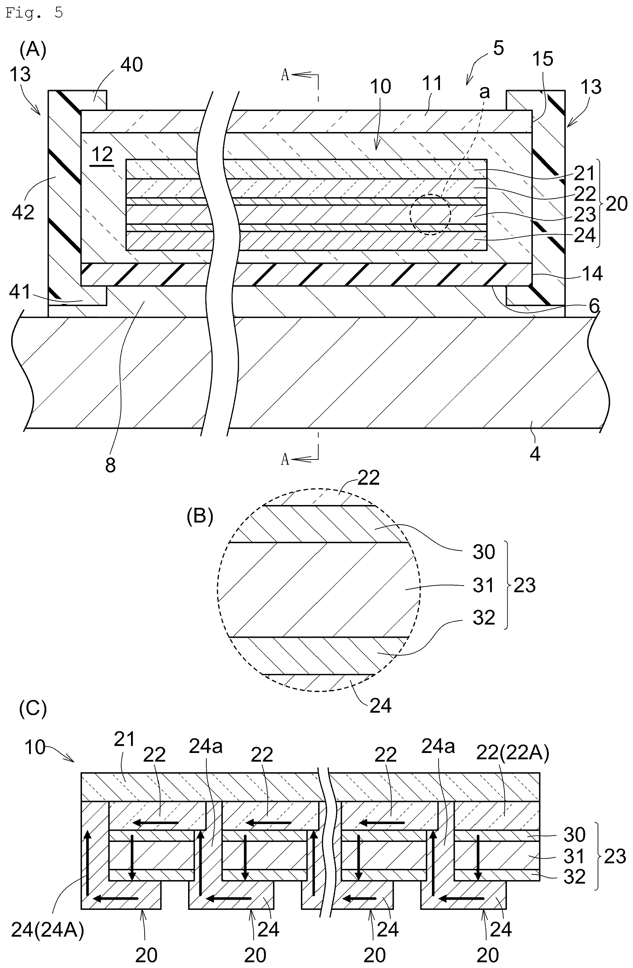

An embodiment of the present invention will be described below with reference to the attached drawings. Fig. 3 is a plan view of a solar power generation system 100 that includes a laminated body 1 according to the embodiment of the present invention. Fig. 4 is a side view of the solar power generation system 100 that includes the laminated body 1 according to the embodiment of the present invention. Fig. 5(A) is a cross-sectional view of a portion of the solar power generation system 100. Fig. 5(B) is an enlarged view of an area a in Fig. 5(A). Fig. 5(C) is a cross-sectional view of a later-described power generation unit 10 taken along a line A-A in Fig. 5(A).

### Overall configuration of solar power generation system 100 and laminated body 1

The solar power generation system 100 according to the present embodiment includes an installation surface 3, an elastic body 4, and a solar power generation device 5. The laminated body 1 according to the present embodiment constitutes a portion of the solar power generation system 100, and includes the aforementioned installation surface 3 and elastic body 4, and a back sheet 6 constituting a bottom section of the solar power generation device 5.

### Installation surface 3

The installation surface 3 is constituted by a fiber-containing sheet (hereinafter, the reference numeral "3" for the installation surface is used as a reference numeral for the fiber-containing sheet as appropriate). The fiber-containing sheet 3 is placed on the ground 2 for the purpose of weed prevention, and is fixed to the ground 2 by means of a pile 7 that extends through the fiber-containing sheet 3 and is buried in the ground 2 on its leading end side. The number of piles 7 and the installation position thereof are not specifically limited and may be set in any manner as long as the fiber-containing sheet 3 can be fixed. The elastic body 4 is placed on the installation surface (the upper surface of the fiber-containing sheet 3). The back sheet 6 is placed on the upper surface of the elastic body 4.

### Solar power generation device 5

The solar power generation device 5 has a sheet shape and can generate electric power by receiving sunlight. As used herein, the term "sheet shape" means a shape in which the thickness of the object is 10% or less of the maximum length between the outer edges in a plan view. If the shape in a plan view rectangular, the "maximum length between the outer edges in a plan view" means the length of the diagonal. If the shape in a plan view is circular, "the maximum length between the outer edges in a plan view" means the length of the diameter. In this specification, a film shape, a foil shape, a film shape, and the like are also included in the "sheet shape".

The solar power generation device 5 has a substantially rectangular shape in a plan view. However, the shape of the solar power generation device 5 of the present invention may alternatively be, for example, substantially circular in a plan view, oval in a plan view, polygonal in a plan view, and there are no particular restrictions.

As shown in Fig. 5(A), the solar power generation device 5 is a device that generates electric power in response to light incident on a light-receiving surface, and includes the above-mentioned back sheet 6, a power generation unit 10, a barrier sheet 11, a sealant 12, and a sealing edge material 13. The barrier sheet 11 constitutes a light-receiving surface 6 of the solar power generation device 5, and is located on the opposite side to the back sheet 6 in the thickness direction of the solar power generation device 5. The power generation unit 10 is located between the back sheet 6 and the barrier seat 11. The sealant 12 fills a space surrounding the power generation unit 10 between the barrier sheet 11 and the back sheet 6. The sealing edge material 13 seals between an outer edge 14 of the back sheet 6 and an outer edge 15 of the barrier sheet 11.

The solar power generation device 5 has flexibility. As used herein, "having flexibility" means the property that the object can bend. The bending strength of the solar power generation device 5 according to the present embodiment is not specifically limited, but preferably 10 MPa or greater, more preferably 20 MPa or greater, more preferably 50 MPa or greater. Also, the bending strength of the solar power generation device 5 is preferably 200 MPa or less, more preferably 150 MPa or less, more preferably 50 MPa or less. The solar power generation device 5 may also be defined by the bending elastic modulus, which is preferably 100 MPa or greater, more preferably 500 MPa or greater. Meanwhile, the bending elastic modulus of the solar power generation device 5 is preferably 10000 MPa or greater, and preferably 5000MPa or less. When defining the solar power generation device 5 in terms of the bending elastic modulus, the bending strength does not need to be included in the above range. The method for measuring the bending strength and the bending elastic modulus of the solar power generation device 5 conforms to JIS K 7171. Thus, the solar power generation device 5 having flexibility allows it to follow the shape of the installation surface 3 and to be unlikely to flap in the wind in the installed state.

### Back sheet 6

The back sheet 6 has barrier performance against water vapor and protection performance against external forces. The back sheet 6 may have translucency, but does not necessarily need to have translucency.

As used herein, "having translucency" means that the light transmittance is 10% or greater relative to the peak wavelength of light before incidence.

The back sheet 6 has flexibility. The back sheet 6 preferably has a longitudinal elastic coefficient of 2400 MPa or greater, more preferably 3000 MPa or greater. The back sheet 6 preferably has a longitudinal elastic coefficient of 4200 MPa or less, more preferably 3100 MPa or less. Examples of the material of the back sheet 6 include synthetic resins such as thermoplastic resins, thermosetting resins, general-purpose plastics, engineering plastics, and vinyl resins (e.g., polyvinyl chloride). In addition to synthetic resins, natural resins, rubbers, metals, carbons, pulps, and the like may also be included in the examples of the material of the back sheet 6.

The thickness of the back sheet 6 is preferably 50 µm or greater, more preferably 100 µm or greater. Also, the thickness of the back sheet 6 is preferably 2000 µm or less, more preferably 1000 µm or less.

The back sheet 6 is fixed in a state placed on the upper surface of the elastic body 4 by being adhered to the upper surface of the elastic body 4 using the adhesive 8.

The adhesive 8 may be, for example, a resin composition containing at least one material selected from vinyl acetate resin, ethylene vinyl acetate resin, epoxy resin, cyanoacrylate resin, acrylic resin, chloroprene rubber, styrene, butadiene rubber, polyurethane resins, silicone resins, modified silicone resins. Note that the present invention does not limit the adhesive 8 to the above-mentioned resin composition. The adhesive 8 preferably has a viscosity of 800 cP or greater, but the viscosity of the adhesive may alternatively be less than 800cP. Note that the laminated body 1 may contain an adhesive elastic resin that serves as both the adhesive 8 and the elastic body 4.

### Power generation unit 10

The power generation unit 10 includes power generation cells 20, which are photoelectric conversion elements utilizing the photovoltaic effect. The power generation unit 10 in the present embodiment includes a photoelectric conversion unit in which a plurality of power generation cells 20 are arranged in the surface direction of the solar power generation device 5 (e.g., the long-side direction or width direction of the solar power generation device 5). Note that the power generation unit 10 may alternatively be constituted by one power generation cell 20.

### Power generation cell 20

Each power generation cell 20 includes a translucent substrate 21, a translucent conductive layer 22, a power generation layer 23, and an electrode 24. The translucent substrate 21, the translucent conductive layer 22, the power generation layer 23, and the electrode 24 are stacked in this order along the direction from the barrier sheet 11 toward the back sheet 6. That is, these layers are arranged such that the translucent substrate 21 faces the barrier sheet 11 and the electrode 24 faces the back sheet 6.

### Translucent substrate 21

The translucent substrate 21 supports the translucent conductive layer 22, the power generation layer 23, and the electrode 24. The translucent substrate 21 has translucency. The translucency of the translucent substrate 21 need only be 10% or greater relative to the peak wavelength of light before incidence, but is preferably 50% or greater, more preferably 80% or greater. As used herein, "being transparent" refers to having a light transmittance of 80% or greater relative to the peak wavelength of light before incidence.

Examples of the material of the translucent substrate 21 include inorganic materials, organic materials, and metallic materials. Examples of the inorganic materials include quartz glass and alkali-free glass. Examples of the organic materials include plastics such as polyethylene terephthalate (PET), polyethylene naphthalate (PEN), polyethylene, polyimide, polyamide, polyamideimide, liquid crystal polymers, and cyclo-olefin polymers, as well as polymer films. Examples of the metal materials include stainless steel, aluminum, titanium, and silicon.

The thickness of the translucent substrate 21 is not specifically limited if it can support the translucent conductive layer 22, the power generation layer 23, and the electrode 24, and may be, for example, 10 µm or greater and 300 µm or less.

The translucent substrate 21 is a substrate required in the production process of the power generation cell 20, but not necessarily a required component. The translucent substrate 21 may, for example, be used only during the production of the solar power generation device 5, and may be removed after or during production. In the case of removal, a non-translucent substrate may be used instead of the translucent substrate 21.

### Translucent conductive layer 22

The translucent conductive layer 22 is a conductive layer and serves as a cathode. The translucent conductive layer 22 has translucency. It is preferable that the transparent conductive layer 22 is transparent.

Examples of the material of the transparent conductive layers 22 include transparent materials such as indium tin oxide (ITO), F-doped tin oxide (FTO), and Nesa film. The translucent conductive layer 22 is formed on the surface of the translucent substrate using, for example, the sputtering method, ion plating method, plating method, coating method, or the like.

Further, the translucent conductive layer 22, may also be configured to have translucency by forming a pattern that can transmit light, while using a non-translucent material. Examples of the non-translucent material include platinum, gold, silver, copper, aluminum, rhodium, indium, titanium, nickel, tin, zinc, or alloys containing these. Examples of the pattern that can transmit light include lattice, linear, wavy, honeycomb-shaped, and round-hole-shaped patterns.

The thickness of the translucent conductive layer 22 is preferably 30 nm or greater and 300 nm or less, for example. When the transparent conductive layer 22 is 30 nm or greater and 300 nm or less, good conductivity can be achieved while maintaining high flexibility.

### Power generation layer 23

The power generation layer 23 is a layer that causes photoelectric conversion when irradiated with light, and generates electrons and holes from excitons generated by absorbing light. As shown in Fig. 5(B), the power generation layer 23 includes a hole transport layer 30, a photoelectric conversion layer 31, and an electron transport layer 32. The hole transport layer 30, the photoelectric conversion layer 31, and the electron transport layer 32 are stacked in this order along the direction from the translucent conductive layer 22 toward the electrode 24.

### Hole transport layer 30

The hole transport layer 30 extracts holes generated in the photoelectric conversion layer 31 to the translucent conductive layer 22 and prevents electrons generated in the photoelectric conversion layer 31 from moving to the translucent conductive layer 22. The material of the hole transport layer 30 may be , for example, a metal oxide. Examples of the metal oxide include titanium oxide, molybdenum oxide, vanadium oxide, zinc oxide, nickel oxide, lithium oxide, calcium oxide, cesium oxide, and aluminum oxide. In addition, any other material such as delafossite-type compound semiconductor (CuGaO2), copper oxide, copper thiocyanate (CuSCN), vanadium pentoxide (V2O5), or graphene oxide may also be used. A p-type organic semiconductor or p-type inorganic semiconductor can also be used as a material of the hole transport layer 30.

The thickness of the hole transport layer 30 is, for example, preferably 1 nm or greater and 1000 nm or less, more preferably 10 nm or greater and 500 nm or less, even more preferably 10 nm or greater and 50 nm or less. The thickness of the hole transport layer 30 being 1 nm or greater and 1000 nm or less can realize the hole transport.

### Photoelectric conversion layer 31

The photoelectric conversion layer 31 (photoactive layer) is a layer that performs photoelectric conversion on absorbed light. The material of the photoelectric conversion layer 31 is not specifically limited if it can perform photoelectric conversion on absorbed light, and examples of the material include amorphous silicon, perovskite, and non-silicon material (CIGS semiconductor material). The photoelectric conversion layer 31 may also use a tandem laminated structure that combines these materials. The photoelectric conversion layer 31 using non-silicon material uses the CIGS semiconductor material, which contains copper (Cu), indium (In), gallium (Ga), and selenium (Se), making it easy to reduce the thickness of the photoelectric conversion layer.

As an example of the photoelectric conversion layer 31, a photoelectric conversion layer using perovskite is described below. The photoelectric conversion layer 31 containing a perovskite compound has the advantage that the dependence of power generation efficiency on the incident light angle (hereinafter referred to as "incidence angle dependence" in some cases) is relatively low. This allows higher power generation efficiency in the present embodiment.

A perovskite compound is a perovskite crystal structure or a structure having a similar crystal. A perovskite crystal structure is represented by the composition formula ABX3. In this composition formula, for example, A denotes an organic cation, B denotes a metal cation, and X denotes a halogen anion. However, the A site, the B site and the X site are not limited thereto.

The organic group of the organic cation that constitutes the A site is not specifically limited, and examples thereof include alkylammonium derivatives and formamidinium derivatives. The A site may be constituted by one type or two or more types of organic cations.

The metal of the metal cation that constitutes the B site is not specifically limited, and examples thereof include Cu, Ni, Mn, Fe, Co, Pd, Ge, Sn, Pb, and Eu. The B site may be constituted by one type or two or more types of metal cations.

The halogen of the halogen anion that constitutes the X site is not specifically limited, and examples thereof include F, Cl, Br, and I. The X-site may consist of one type or two or greater halogen anions.

The thickness of the photoelectric conversion layer 31 is preferably 1 nm or greater and 1000000 nm or less, more preferably 100 nm or greater and 50000 nm or less, even more preferably 300 nm or greater and 1000 nm or less, for example. The thickness of the photoelectric conversion layer 31 being 1 nm or greater and 1000000 nm or less increases the photoelectric conversion efficiency.

### Electron transport layer 32

The electron transport layer 32 extracts electrons generated in the photoelectric conversion layer 31 to the electrode 24, and prevents holes generated in the photoelectric conversion layer 31 from moving to the electrode 24. The electron transport layer 32 preferably embraces either a halogenated compound or metal oxides, for example.

Examples of the halogenated compounds include lithium halide (LiF, LiCl, LiBr, Lil), and sodium halide (NaF, NaCl, NaBr, NaI). Examples of elements constituting the metal oxide include titanium, molybdenum, vanadium, zinc, nickel, lithium, potassium, cesium, aluminum, niobium, tin, and barium. An n-type organic semiconductor or an n-type inorganic semiconductor can also be used as the material of the electron transport layer 32.

The thickness of the electron transport layer 32 is preferably 1 nm or greater and 1000 nm or less, more preferably 10 nm or greater and 500 nm or less, even more preferably 10 nm or greater and 50 nm or less, for example. The thickness of the electron transport layer 32 being 1 nm or greater and 1000 nm or less can realize electron transport.

### Electrode 24

The electrode 24 has conductivity and functions as an anode. The electrode 24 can extract electrons from the photoelectric conversion layer 31 in response to photoelectric conversion caused by the photoelectric conversion layer 31. The electrode 24 may has translucency or may be constituted by a non-translucent material. Examples of the material of the electrode 24 include platinum, gold, silver, copper, aluminum, rhodium, indium, titanium, nickel, tin, zinc, and alloys containing these.

### Barrier seat 11

The barrier sheet 11 is located on the opposite side to the back sheet 6 in the thickness direction of the solar power generation device 5. The barrier sheet 11 includes the light-receiving surface of the solar power generation device 5. The barrier sheet 11 has translucency. The barrier sheet 11 is preferably transparent. The barrier sheet 11 has barrier performance against water vapor and protective performance against external forces.

The barrier sheet 11 has flexibility. The material used for the barrier sheet 11 preferably has a longitudinal elastic coefficient of 100 Pa or greater and 10000 MPa or less, more preferably 1000 MPa or greater and 5000 MPa or less. Specifically, examples of the material of the barrier sheet 11 include plastic films and vinyl films.

The thickness of the barrier sheet 11 is preferably 50 µm or greater, more preferably 100 µm or greater. Also, the thickness of the barrier sheet 11 is preferably 2000 µm or less, more preferably 1000 µm or less. The thickness of the barrier sheet 11 being 50 µm or greater and 2000 µm or less makes it easy to set the bending strength of the solar power generation device 5 to 50 MPa or greater and 150 MPa or less.

### Sealant 12

The sealant 12 is filled between the barrier sheet 11 and the back sheet 6 with the power generation layer 23 located between the barrier sheet 11 and the back sheet 6. The sealant 12 prevents the power generation layer 23 from being exposed to water entering from around the power generation layer 23. The sealant 12 has translucency, and is preferably transparent. Note that the sealant 12 does not necessarily need to cover the entire power generation unit 10. For example, if a portion of the power generation unit 10 is exposed from the sealant 12, the exposed portion may be covered with the sealant edge material 13 or the like.

Examples of the material of the sealant 12 include ethylene vinyl acetate (EVA), polyolefin, butyl rubber, silicone resin, polyvinyl butyral, acrylic resin, polyisobutylene resin, SBS resin, SIBS resin, and epoxy resin.

The transverse elastic modulus of the sealant 12 is preferably 0.01 MPa or greater and 500 MPa or less, more preferably 0.05 MPa or greater and 250 MPa or less, even more preferably 0.1 MPa or greater and 100 MPa or less. With this, the sealant 12 is deformed in the surface direction following thermal expansion/contraction caused by the temperature difference between the back sheet 6 and the barrier sheet 11. This prevents delamination of the back sheet 6 and the barrier sheet 11 from the sealant 12 due to shear stress generated by thermal expansion/contraction. As used herein, the "transverse elastic modulus" refers to a value calculated from the longitudinal elastic coefficient and the Poisson's ratio obtained by the tensile test method.

From another viewpoint, the sealant 12 can also be specified in terms of viscosity. The viscosity of the sealant 12 is preferably 11000 mPa·S or greater and 700000 mPa·S or less, more preferably 26000 mPa·S or greater and 450000 mPa·S or less, even more preferably 40000 mPa·S or greater and 110000 mPa·S or less.

Examples of the material of the sealant 12 in this case include polyolefin, butyl rubber, silicone resin, polyvinyl butyral, acrylic resin, and polyisobutylene resin. As used herein, the "viscosity" is a value measured at an environmental temperature of 23°C in accordance with the rotational viscometer method of JIS Z8803.

The back sheet 6 and the barrier sheet 11 are adhered together via the sealant 12, and the adhesive strength here is preferably 0.1 N/10 mm or greater and 10 N/10 mm or less in a peel test. In particular, since the shear stress occurring in the solar power generation device 5 is greater when it is constructed in a bent state, adopting the adhesive strength in the above range in the peel test can effectively suppress delamination for a long period of time. The peel test is conducted in accordance with JIS Z 0237.

From the viewpoint of enhancing the effect of suppressing delamination, the thickness of the sealant 12 is preferably 10 µm or greater, more preferably 30 µm or greater, even more preferably 50 µm or greater. Meanwhile, the thickness of the sealant 12 is preferably less than 300 µm or less, preferably 200 µm or less, even more preferably 100 µm or less. The thickness of the sealant 12 being to 10 µm or greater makes it possible to secure sufficient escape of shear stress when thermal expansion/contraction occurs. The thickness of the sealant 12 being 300 µm or less can reduce the weight of the solar power generation device 5, thereby improving constructability and workability.

### Sealing edge material 13

The sealing edge material 13 seals between the outer edge 14 of the back sheet 6 and the outer edge 15 of the barrier sheet 11, with a plurality of power generation cells 20 and the sealant 12 located between the back sheet 6 and the barrier sheet 11. The sealing edge material 13 constitutes the outer edge of the solar power generation device 5. As shown in Fig. 5(A), the sealing edge material 13 has a first adhesive section 40, a second adhesive section 41, and a sealing section 42 connecting the first adhesive section 40 and the second adhesive section 41. The first adhesive section 40 is adhered to the front surface (upper surface in the figure) of the barrier sheet 11. The second adhesive section 41 is adhered to the back surface (lower surface in the figure) of the back sheet 6. The first adhesive section 40, the sealing section 42, and the second adhesive section 41 are integral.

Examples of the material of the sealing edge material 13 include a tape material made of butyl rubber, silicone rubber, or the like.

Note that in the present embodiment, the sealing edge material 13 is not necessarily required. For example, instead of providing the sealing edge material 13, an edge portion of the barrier sheet 11 may be folded toward the back sheet 6, and the leading end of the folded portion may be joined to the back sheet 6. This eliminates the need for sealing edge material 13.

### Operation of solar power generation device 5

With the above-described solar power generation device 5, when the solar power generation device 5 is irradiated with light from the front surface side (barrier sheet 11 side), the photoelectric conversion layer 31 of the power generation layer 23 absorbs light and performs photoelectric conversion, thereby generating electrons and holes. The electrons are extracted via the electron transport layer 32 to the electrode 24 (anode), and the holes are extracted via the hole transport layer 30 to the translucent conductive layer 22 (cathode), thereby causing a current to flow from the translucent conductive layer 22 toward the electrode 24 (i.e., electric power is generated).

In the photoelectric conversion unit constituting the power generation unit 10, the electrode 24 (anode) of each power generation cell 20 has an extension 24a (Fig. 5(C)). The extension 24a of the electrode 24 extends toward the translucent conductive layer 22 (cathode). Of two adjacent power generation cells 20, the extension 24a of the electrode 24 of one cell 20 is joined to the translucent conductive layer 22 of the other cell 20. With this joint, while the solar power generation device 5 is irradiated with light, a current flows from the translucent conductive layer 22A at an end on one side of the power generation unit 10 (photoelectric conversion unit) to the electrode 24A at an end on the other side of the power generation unit 10 (the current flow is indicated by arrows in Fig. 5(C)). This current is taken out through a distribution line (not shown).

By configuring the power generation unit 10 with the above-mentioned photoelectric conversion unit, the amount of electricity taken out from the power generation unit 10 can be stabilized even if a failure occurs in some power generation cells 20.

Note that instead of providing the electrode 24 (anode) of each power generation cell 20 with the extension 24a, the translucent conductive layer 22 (cathode) of each power generation cell 20 may have an extension extending toward the electrode 24 (anode). In this case, of two adjacent power generation cells 20, the extension of the translucent conductive layer 22 of one cell 70 is joined to the electrode 24 of the other cell 70. This can also achieve the same effect as above.

When the translucent substrate 21 is provided in the power generation unit 10, it is preferable to have the translucent conductive layer 22, the power generation layer 23, and the electrode 24 of each power generation cell 20 supported by a common translucent substrate 21 as shown in Fig. 5(C) from the viewpoint of facilitating the production of the power generation unit 10.

When the power generation unit 10 is constituted by one power generation cell 20, the current flowing from the electrode 24 to the translucent conductive layer 22 is taken out through a distribution line.

Note that the solar power generation device 5 may include a plurality of power generation units 10. In this case, the plurality of power generation units 10 are arranged in the surface direction of the solar power generation device 5 and are electrically connected in series or in parallel.

When each power generation unit 10 is constituted by the photoelectric conversion unit, in order to connect the plurality of power generation units 10 in series, the translucent conductive layer 22A at an end of one power generation unit 10, of two adjacent power generation units 10, is connected to the electrode 24A at an end of the other power generation unit 10 via a distribution line. When a plurality of power generation units 10 are connected in parallel, the transparent conductive layers 22A and 12A at ends of two adjacent power generation units 10 are electrically connected to each other, and the electrodes 24A at ends of the two adjacent power generation units 10 are connected to each other, via respective distribution lines.

When the power generation unit 10 is constituted by one power generation cell 20, in order to connect a plurality of power generation units 10 in series, the transparent conductive layer 22 of one power generation unit, of two adjacent power generation units 10, and the electrode 24 of the other power generation unit are connected via a distribution line. When the plurality of power generation units 10 are connected in parallel, the translucent conductive layers 22 and 12 of the two adjacent power generation units 10 are connected to each other, and the electrodes 24 and 14 of the two adjacent power generation units are connected to each other, via respective distribution lines.

Note that when the power generation unit 10 is constituted by either the above-mentioned photoelectric conversion unit or one power generation cell 20, similarly, the distance between adjacent power generation units 10 need only be greater than 0 mm, preferably 2 mm or greater, more preferably 10 mm or greater, even more preferably 15 mm or greater. Also, the distance between adjacent power generation units 10 is preferably 100 mm or less, more preferably 50 mm or less, even more preferably 20 mm or less.

### Fiber-containing sheet 3

The fiber-containing sheet 3 constituting the installation surface is a sheet containing fiber and has light shielding properties. The fiber-containing sheet 3 blocks sunlight, thereby preventing vegetation from growing on the ground 2. The tensile strength of the fiber-containing sheet 3 is preferably 1 N/cm or greater and 10000 N/cm or less. The thickness of the fiber-containing sheet 3 is preferably 0.1 mm or greater and 100 mm or less, for example.

The fiber-containing sheet 3 can be a fiber-reinforced sheet with a resin coating around fiber, or a nonwoven fabric. In this case, for example, polyethylene, polypropylene, polyester, polylactic acid, polyolefin, asphalt, or silica sand is used as the material of fiber contained in the fiber-containing sheet 3.

### Elastic body 4

The elastic body 4 is a sheet made of an elastic material. The elastic body 4 has a transverse elastic modulus of preferably 10 MPa or greater and 100 MPa or less, more preferably 0.1 MPa or greater and 10 MPa or less. Alternatively, the elastic body 4 has a viscosity of preferably 0.1 Pa·s or greater and 10000 Pa·s or less, more preferably 1 Pa·s or greater and 1000 Pa·s or less. For example, it is possible to use, as the elastic material for forming the elastic body 4, a resin composition containing at least one selected from vinyl acetate resin, ethylene vinyl acetate resin, epoxy resin, cyanoacrylate resin, acrylic resin, chloroprene rubber, styrene, butadiene rubber, polyurethane resins, silicone resins, and modified silicone resin. The thickness of the elastic body 4 is preferably 0.1 mm or greater and 100 mm or less, for example.

The elastic body 4 is fixed in a state placed on the upper surface (installation surface) of the fiber-containing sheet 3 by being adhered to the upper surface (installation surface) of the fiber-containing sheet 3 using an adhesive 40.

For example, it is possible to use as the adhesive 40 a resin composition containing at least one selected from vinyl acetate resin, ethylene vinyl acetate resin, epoxy resin, cyanoacrylate resin, acrylic resin, chloroprene rubber, styrene, butadiene rubber, polyurethane resins, silicone resin, modified silicone resin. Note that the present invention does not limit the adhesive 40 to the above-mentioned resin composition. It is preferable that the adhesive has a viscosity of 800cP or greater, but the viscosity of the adhesive may alternatively be less than 800cP.

Note that if the back sheet 6 and the installation surface 3 can be adhered together via the elastic body 4, it is not necessary to form the elastic body 4 in a sheet shape. The elastic body 4 may have a shape that allow the back sheet 6 to be partially adhered to the installation surface 3 (e.g., the elastic body 4 may have a shape that allows only the periphery of the back sheet 6 to be adhered to the installation surface 3). In terms of actively deforming the elastic body 4 along with deformation of the back sheet 6 due to thermal expansion/contraction, it is preferable that the back sheet 6 and the installation surface 3 are adhered together only via the elastic body 4. On the other hand, in terms of temporary fixation, fixation with relatively weak strength, and partial fixation considering constructability, a member other than the elastic body 4 may also be provided to adhere the back sheet 6 and the installation surface 3 together. However, in this case, it is necessary to consider that the member other than elastic body 4 do not inhibit the deformation of the back sheet. A mode may be adopted in which the elastic body is applied as an adhesive layer to the installation surface or the back surface of the back sheet of the solar power generation device to attach them together. Also, an adhesive elastic resin that also serves as the above-mentioned adhesive 40 and elastic body 4 may be provided in the laminated body 1.

The ratio (Eb/Ea) between the transverse elastic modulus Ea of the back sheet and the transverse elastic modulus Eb of the elastic body 4 is preferably 0.002 or greater and 0.05 or less. The transverse elastic modulus of the elastic body 4 is preferably 0.1 MPa or greater and 100 MPa or less.

### Operation and effect

With the laminated body 1 and the solar power generation system 100 according to the present embodiment, the elastic body 4 is located between the fiber-containing sheet 3 and the back sheet 6. This causes the elastic body 4 to deform three-dimensionally following thermal expansion/contraction caused by temperature changes of the fiber-containing sheet 3 and the back sheet 6 (i.e., deformation occurs in response to thermal expansion/contraction of the fiber-containing sheet 3 on the fiber-containing sheet 3 side of the elastic body 4, and deformation occurs in response to thermal expansion/contraction of the back sheet 6 on the back sheet 6 side of the elastic body 4). This makes it possible to avoid the occurrence of large shear stress between the sheets (namely, between the fiber-containing sheet 3 and the elastic body 4 and between the elastic body 4 and the back sheet 6), so that the sheets 3 and 6 are less likely to delaminate. Therefore, with the laminated body 1 and the solar power generation system 100, a gap is unlikely to occur between the fiber-containing sheet 3 constituting the installation surface and the back sheet 6, and the solar power generation device 5 can be fixed stably for a long period of time.

Note that, from the viewpoint of keeping stress occurring in the laminated body 1 due to thermal expansion/contraction small, the elastic modulus of the elastic body 4 is preferably 0.1 MPa or greater and 1000 MPa or less. In terms of suppressing generated stress, it is preferable to lower the elastic modulus of the elastic body 4. However, the lower the elastic modulus of the elastic body 4, the lower the shape retention of the elastic body 4, so that the elastic modulus of the elastic body 4 is preferably 0.1 MPa or greater as mentioned above. In addition, the higher the elastic modulus of the elastic body 4, the larger the stress occurring in the elastic body 4, so that the elastic modulus of the elastic body 4 is preferably 1000 MPa or less.

It is preferable that the linear expansion coefficient of the elastic body 4 is larger than the linear expansion coefficient of the fiber-containing sheet 3 and smaller than the linear expansion coefficient of the back sheet 6. This can keep the shear stress occurring between the sheets small. Note that in the above case, the linear expansion coefficient of the fiber-containing sheet 3 is preferably 1×10-6/°C or greater and 1000×10-6°C or less, and the linear expansion coefficient of the elastic body 4 is preferably 10×10-6/°C or greater and 1000×10-6°C or less and takes a value smaller than the linear expansion coefficient of the back sheet 6.

From the viewpoint of maintaining a stable joint between the fiber-containing sheet 3 and the elastic body 4 via the elastic body 4, the sheer peel strength of the fiber-containing sheet 3 and the back sheet 6 via the elastic body 4 is preferably 0.1 N/cm or greater. The above shear peel strength is a value measured using the JIS K6850 method. The sheer peel strength of 0.1 N/cm or greater can be achieved by, for example, selecting the materials of the fiber-containing sheet 3 and the adhesive 40 as appropriate. When measuring the sheer peel strength, it is preferable to perform measurement under an environmental temperature higher than the operating temperature, and it is preferable to perform measurement under an environmental temperature of 90°C, for example. On the other hand, if, for example, it is clear that the operating environment temperature is a certain low temperature, measurement at about that operating environment temperature is preferable.

### Variations

The present invention is not limited to the above embodiment and can be modified in various ways. Variations and the like of the present invention will be described below (in the following, constituents common to the above embodiment are assigned the same reference numerals as the above embodiment, and the detailed description thereof is omitted.)

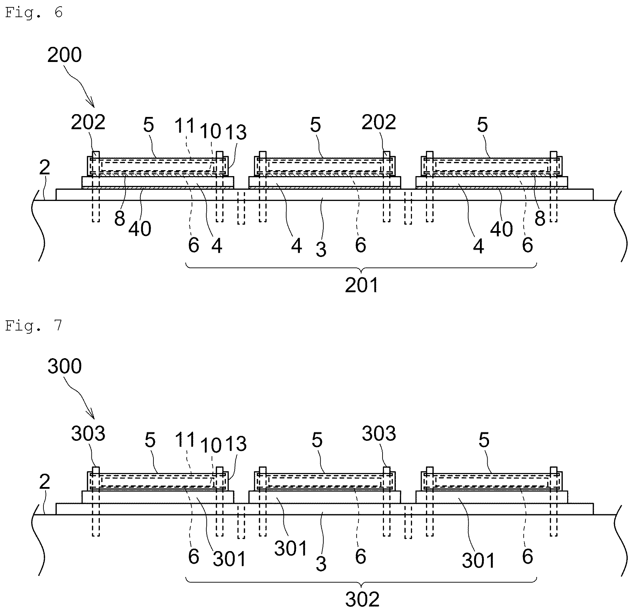

For example, the solar power generation system of the present invention can be varied as shown in Fig. 6. A solar power generation system 200 shown in Fig. 6 is installed on the ground 2 and includes the fiber-containing sheet 3 constituting the installation surface, the elastic body 4, and the solar power generation device 5. A portion of the solar power generation system 200 is constituted by a laminated body 201, which includes the fiber-containing sheet 3, the elastic body 4, and the back sheet 6 constituting the bottom section of the solar power generation device 5. In the solar power generation system 200, the elastic body 4 is adhered to the upper surface (installation surface) of the fiber-containing sheet 3 using the adhesive 40, and the back sheet 6 is adhered to the upper surface of the elastic body 4 using the adhesive 8. In addition, the leading end side of a pile 202 that extends through the solar power generation device 5, the elastic body 4, and the fiber-containing sheet 3 is buried in the ground, thereby fixing the solar power generation device 5, the elastic body 4, and the fiber-containing sheet 3. This stably maintains the positions of the fiber-containing sheet 3, the elastic body 4, and the solar power generation device 5.

The solar power generation system of the present invention can also be varied as shown in Fig. 7. A solar power generation system 300 shown in Fig. 7 is installed on the ground 2 and includes the fiber-containing sheet 3 constituting the installation surface, an elastic body 301, and the solar power generation device 5. A portion of the solar power generation system 300 is constituted by a laminated body 302, which includes the fiber-containing sheet 3, the elastic body 301, and the back sheet 6 constituting the bottom section of the solar power generation device 5.

The elastic body 301 is made of a material having elasticity and adhesiveness. Due to the elastic body 301 having adhesiveness, the elastic body 301 is fixed in a state placed on the upper surface (installation surface) of the fiber-containing sheet 3, and the back sheet 6 is fixed in a state placed on the upper surface of the elastic body 301. It is possible to use as the material of the elastic body 301, for example, a resin composition containing at least one selected from vinyl acetate resin, ethylene vinyl acetate resin, epoxy resin, cyanoacrylate resin, acrylic resin, chloroprene rubber, styrene, butadiene rubber, polyurethane resin, silicone resin, and modified silicone resin. The thickness of the elastic body 301 is, for example, 0.1 mm or greater, preferably 1 mm or greater, more preferably 5 mm or greater, and is 100 mm or less, more preferably 50 mm or less, even more preferably 10 mm or less. From the viewpoint of maintaining a stable joint between the fiber-containing sheet 3 and the back sheet 6 via the elastic body 301, the sheer peel strength of the fiber-containing sheet 3 and the back sheet 6 via the elastic body 301 is preferably 0.1 N/cm or greater (the above sheer peel strength is a value measured using the JIS K6850 method).

With the above laminated body 302 and solar power generation system 300, the elastic body 301, which is located between the fiber-containing sheet 3 and the back sheet 6, has elasticity and thus deforms three-dimensionally following thermal expansion/contraction caused by temperature changes of the fiber-containing sheet 3 and the back sheet 6 (i.e., deformation occurs in response to thermal expansion/contraction of the fiber-containing sheet 3 on the fiber-containing sheet 3 side of the elastic body 301, and deformation occurs in response to thermal expansion/contraction of the back sheet 6 on the back sheet 6 side of the elastic body 301). This makes it unlikely for a gap to occur between the sheets (namely, between the fiber-containing sheet 3 and the elastic body 301 and between the elastic body 301 and the back sheet 6), allowing the solar power generation device 5 to be fixed stably for a long period of time. In addition, the elastic body 301 having adhesiveness can easily realize the joint of the fiber-containing sheet 3, the elastic body 301, and the back sheet 6. Note that in the illustrated example, a pile 303 is used that extends through the solar power generation device 5, the elastic body 301, and the fiber-containing sheet 3 and is stuck into the ground. However, this pile 303 may be omitted, and the pile 7 that extends through the fiber-containing sheet 3 and is stuck into the ground may alternatively be used as in the example of Fig. 4.

In the solar power generation systems 100, 200, and 300 in the illustrated examples (Figs. 3, 4, 6, and 7), three sets of "the elastic body 4 or 301 and the solar power generation device 5" are provided on the fiber-containing sheet 3. However, multiple sets other than three sets of "the elastic body 4 or 301 and the solar power generation device 5" may alternatively be provided on one fiber-containing sheet 3. Alternatively, one set of "the elastic body 4 or 301 and the solar power generation device 5" may be provided on one fiber-containing sheet 3. When multiple sets of "the elastic body 4 or 301 and the solar power generation device 5" are provided on one fiber-containing sheet 3, the laminated body 1, 201, or 302 includes one fiber-containing sheet 3 and a plurality of elastic bodies 4 or 301 placed on the upper surface of the fiber-containing sheet 3, and the back sheet 6 placed on the upper surface of each of the elastic bodies 4 or 301. If one set of "the elastic body 4 or 301 and the solar power generation device 5" is provided on one fiber-containing sheet 3, the laminated body 1, 201, or 302 includes one fiber-containing sheet 3, one elastic body 4 or 301 placed on the upper surface of the fiber-containing sheet 3, and one back sheet 6 placed on the upper surface of the one elastic body 4 or 301.

Figs. 3, 4, 6 and 7 show the examples in which the solar power generation systems 100, 200 and 300 are installed on the ground 2, but the solar power generation systems 100, 200 and 300 may alternatively be installed on the surface of a roof. In this case, the laminated body 1 constituting the solar power generation system 100, the laminated body 201 constituting the solar power generation system 200, and the laminated body 302 constituting the solar power generation system 300 each include the fiber-containing sheet 3 placed on the surface of the roof, the elastic body 4 or 301 placed on the upper surface (installation surface) of the fiber-containing sheet 3, and the back sheet 6 of the solar power generation device 5 placed on the upper surface of the elastic body 4 or 301. Further, for example, the fiber-containing sheet 3 is fixed to the surface of the roof using a pile or the like that extends through the fiber-containing sheet 3 and has its leading end side embedded in the roof. Alternatively, the above-mentioned pile may be omitted, and the leading end side of a pile that extends through the solar power generation device 5, the elastic body 4, and the fiber-containing sheet 3 may be embedded in the roof. The elastic body 4 included in the laminated body 1, 201 (Fig. 4, 6) is fixed in a state placed on the upper surface of the fiber reinforced sheet 3 by being adhered to the upper surface of the fiber reinforced sheet 3 using the adhesive 40. The back sheet 6 included in the laminated body 1, 201 (Fig. 4, 6) is fixed in a state placed on the upper surface of the elastic body 4 by being adhered to the upper surface of the elastic body 4 using the adhesive 8. In the case of the laminated body 302 (Fig. 7), the elastic body 301, due to having adhesiveness, is fixed in a state placed on the upper surface of the fiber-containing sheet 3, and the back sheet 6 is fixed in a state placed on the upper surface of the elastic body 301.

The installation surface 3 may be a surface parallel with a horizontal plane (a plane perpendicular to the direction in which gravity acts) or may be a surface that intersects with the horizontal plane at an angle. The installation surface 3 that intersects with a horizontal plane at an angle includes an inclined surface that forms a predetermined inclination angle θ (0°<θ<90°) with the horizontal plane, and a vertical surface perpendicular to the horizontal plane. The installation surface 3 may be flat or curved, and its surface condition may be smooth, rough, or uneven. The installation surface 3 is made of, for example, metal, hard or soft resin, asphalt, concrete, ceramics, or the like. When the installation surface is uneven, the maximum bending radius of the solar power generation device 5 is preferably 50 mm or greater, more preferably 75 mm or greater, even more preferably 100 mm or greater. The above or greater bending radius allows application to various installation surfaces while suppressing damage to the solar power generation device 5.

The installation surface 3 may alternatively be constituted by a surface of a building material. Examples of the building material include roofing materials, wall materials (metal siding materials, ceramic siding materials, sandwich panels etc.), partitions, door materials, fence materials, flooring materials, window glass, and balconies. Examples of the roofing materials include roofing materials used for folded plate roofs, slate roofs, roof decks, tile roofs, and standing flat roofs. The roof may be a vertical or horizontal roof.

The method of attachment onto the roof can be selected according to the construction form on the roof and the roof design. Construction on the roof may be carried out by lifting the solar power generation device 5 in a rolled state onto the roof and then spreading it out. Alternatively, it is also possible to place the solar power generation device 5 in a rolled state on the ground or outside the roof, and pull it up onto the roof and install it while gradually pulling out the solar power generation device 5 from the rolled body obtained by rolling the solar power generation device 5.

Buildings in which the solar power generation device 5 is used may be non-residential or residential buildings. Examples of the non-residential buildings include stores, warehouses, factories, meeting venues, gymnasiums, and parking lots. Examples of the residential buildings include wooden houses, steel houses, reinforced concrete houses, and aluminum houses. Of these, in the case of a non-residential building that is a large-scale building, it is preferable that the solar power generation device 5 has a long length. In this case, it is preferable that the length of the solar power generation device 5 in the long-side direction is three times or greater the length of the solar power generation device 5 in the width direction. For example, the solar power generation device 5 has a length in the long-side direction that is 10 times or greater the length in the width direction, more specifically, 15 times or greater, even more specifically, 20 times or greater. The lower limit value of the length of the solar power generation device 5 in the long-side direction is not specifically limited, but it is preferable to be 100 times or less the length in the width direction, and more specifically, 50 times or less, for example.

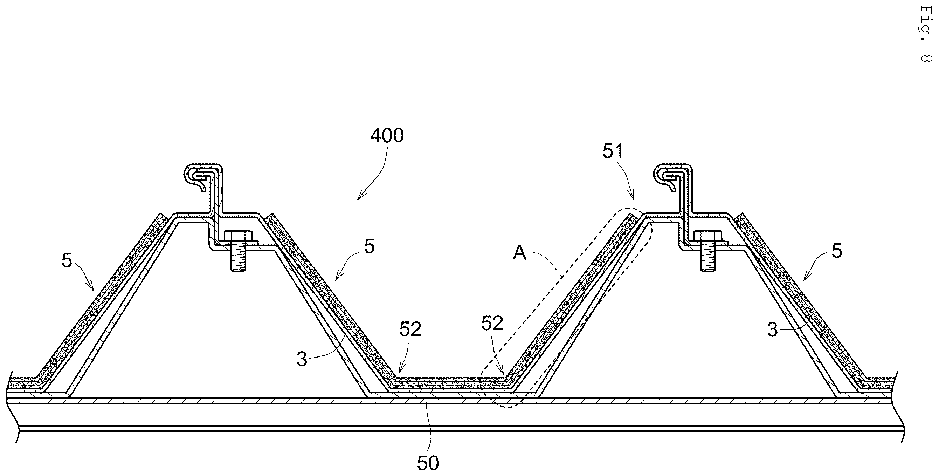

Fig. 8 shows a solar power generation system 400 having an installation surface 3 constituted by an exterior material (a building material that forms an outer surface of a building) (hereafter, the reference numeral "3" for the installation surface will also be used as a reference numeral for the exterior material as appropriate). The exterior material 3 has a plurality of protrusions 51 that extend in one direction and spaced apart from each other in a direction perpendicular to the one direction. Examples of the exterior material 3 include roofing materials, wall materials (metal siding materials, ceramic siding materials, sandwich panels etc.), partitions, door materials, and fence materials. The exterior material 3 in the present embodiment is a roofing material.

The solar power generation device 5 having this configuration is bent at two locations corresponding to inside corners formed by a valley section 50 and protrusions 51, as shown in Fig. 8. The solar power generation device 5, which has flexibility, allows the above bending operation to be easily performed. The elastic body 4 or 301 (not shown) is fixed in a state placed on the exterior material 3 (installation surface). A back sheet (not shown) constituting a bottom section of the solar power generation device 5 is fixed in a state placed on the upper surface of the elastic body 4 or 301.

Note that the attachment of the elastic body 4 or 301 (not shown) to the exterior material 3 and the attachment of the solar power generation device 5 to the elastic body 4 or 301 (not shown) may be achieved by adhesion, bolting, screwing, magnetic adhesion, pinning, fixing with dedicated fittings, or the like. Examples of the dedicated fittings include a pair of rails extending in a water flow direction. The pair of rails is fixed, for example, to an upper end section of the protrusion 51 of the exterior material 3, and an end section of the solar power generation device 5 and an end section of the elastic body 4 or 301 (not shown) are inserted into the rails.

The solar power generation device 5 has two bent sections 52, as shown in Fig. 8. Therefore, the power generation unit 10 can be provided at least in the areas corresponding to the bent sections 52, thereby improving power generation efficiency compared to, for example, the case where one flat solar power generation device 5 is fixed to each flat surface (the inclined surface of the protrusion 51, the valley portion 50) of the exterior material 3. Meanwhile, even with the bent sections 52, delamination at interlayer interfaces can be suppressed over a long period of time, as mentioned above.

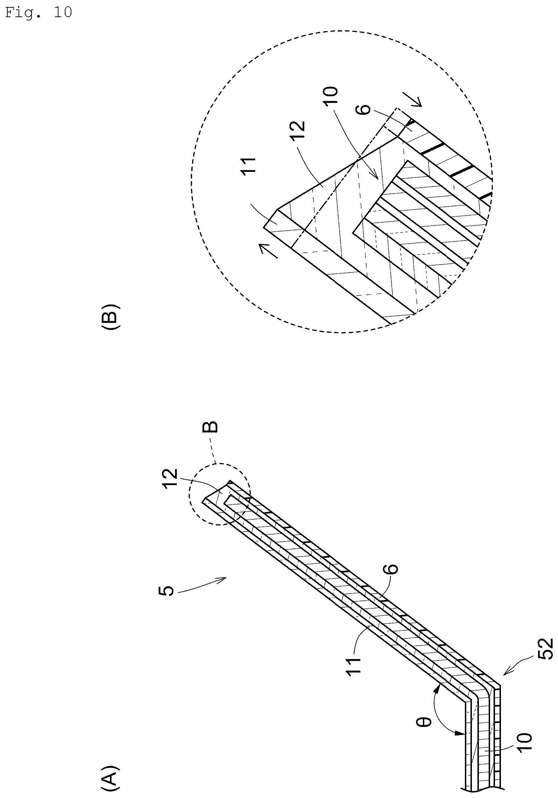

The bent sections 52 are bent portions of the solar power generation device 5. The bent sections 52 may be bent as shown in Fig. 10, for example, but are not limited thereto and may alternatively be curved. As used herein, "being bent" means a form in which the curvature radius at the internal corner is 10 mm or less. "Being curved" means a form in which the curvature radius at the internal corner is greater than 10mm.

The angle θ formed by each bent section 52 need only be smaller than 180°, but is, for example, 90° or greater, more preferably 120° or greater, even more preferably 160° or greater. In the illustrated example, the solar power generation device 5 has two bent sections 52, but may alternatively have one or three or greater bent sections. As used herein, the "angle formed" means the smaller of the two angles between two different faces.

The bent sections 52 may be formed by bending a flat solar power generation device 5 during construction, or the solar power generation device 5 may be formed in a bent form in advance during production. Bending at the site can increase the flexibility in construction. Bending during production minimizes the value of shear stress occurring in the sealant in front and back sheets when bending and fixing the solar power generation device 5.

The solar power generation device 5 is connected with a cable for outputting electricity generated by the power generation unit 10 to an external device such as a power conditioner. The cable may be pulled out from either the back sheet 6 or the barrier sheet 11, but in terms of better appearance it is preferable to pull out the cable from the back sheet 6. On the other hand, in terms of maintainability, it is preferably to pull out the cable from the barrier sheet 11.

In the above solar power generation system 400, the transverse elastic coefficient (transverse elastic modulus) of the sealant 12 is set to 500 MPa or less, or the viscosity of the sealant 12 is set to 11000 mPa·S or greater and 700000 mPa·S or less. Thus, even if expansion/contraction or the like occurs in the surface direction in the barrier sheet 11 and the barrier sheet 6, delamination can be suppressed at the interface between the barrier sheet 11 and the sealant 12 and at the interface between the back sheet 6 and the sealant 12. For example, when the solar power generation device 5 is bent toward the front side as shown in Fig. 10, it is possible that the barrier sheet 11 is compressed and the back sheet 6 is stretched. At this time, a portion of the barrier sheet 11 and a portion of the back sheet 6 are displaced in the surface direction, so that the sealant 12 follows the barrier sheet 11 and the back sheet 6 as shown in Fig. 10(B). However, delamination at the interface between the layers can be suppressed since the sealant 12 is easily deformed.

The delamination strength of the back sheet 6 against the sealant 12 is preferably 0.1 N/mm or greater, more preferably 0.5 N/mm or greater, even more preferably 0.8 N/mm or greater. The delamination strength of the barrier sheet 11 against the sealant 12 is preferably 0.1 N/mm or greater, more preferably 0.5 N/mm or greater, even more preferably 0.8 N/mm or greater.

As used herein, the "delamination strength" is a measurement result obtained by 90° peel test according to JIS K6854-1. The 90° peel test is conducted under the conditions of a peel speed of 300 mm/min, a measurement temperature of room temperature (25°C), and an atmosphere of atmospheric pressure.

By setting the delamination strength of the back sheet 6 against the sealant 12 to 0.1 N/mm or greater as mentioned above, delamination is unlikely to occur at the interface between the back sheet 6 and the sealant 12 even when an external force is applied to the back sheet 6.

Further, since the delamination strength of the barrier sheet 11 against the sealant 12 is 0.1 N/mm or greater as mentioned above, delamination is more unlikely to occur at the interface between the barrier sheet 11 and the sealant 12 even when an external force is applied to the barrier sheet 11.

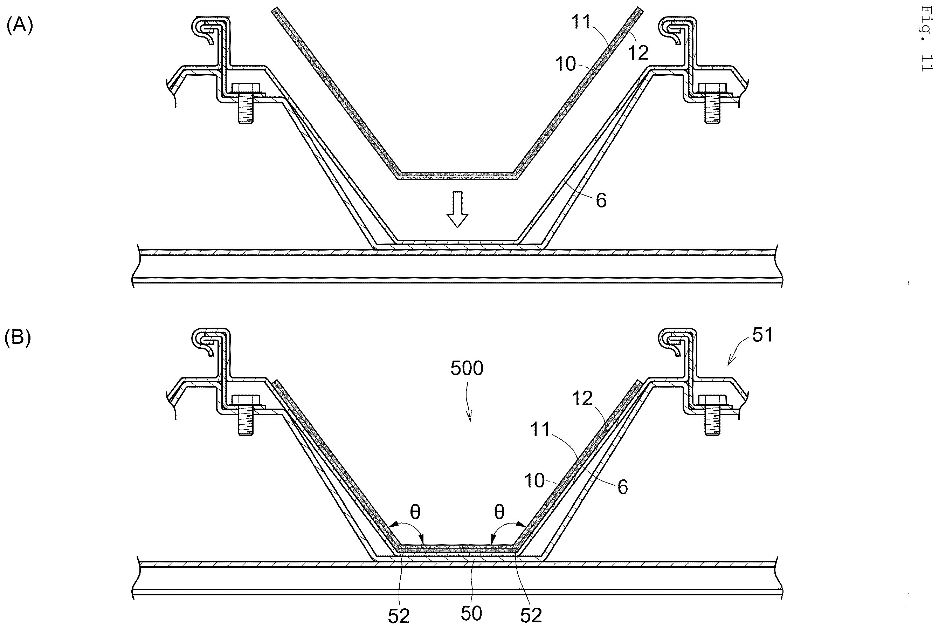

The above-described solar power generation system 400 can also be varied as shown in Fig. 11. A solar power generation system 500 shown in Fig. 11 has a back sheet 6 constituted by a building board (hereinafter, the reference numeral 6 of the back sheet is used as a reference numeral for the building board as appropriate).

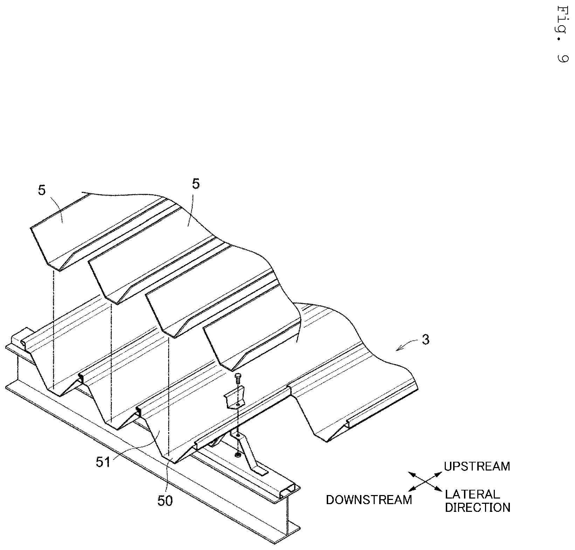

The building board 6 may be a roofing material, a wall material (metal siding material, ceramic siding material, sandwich panel etc.), a partition, a door material, a fence material, or the like. Examples of the roofing material include folded plate roofs, slate roofs, roof decks, tile roofs, and textured roofs (textured exterior materials) used in standing flat roofs and the like. The roof may be vertical or horizontal. The building board 6 shown in Fig. 11 has the same shape as the exterior material 3 shown in Figs. 8 and 9, and the detailed description thereof is omitted accordingly.

The building board 6 is constituted by a metal plate. Examples of the metal plate include painted steel plates, stainless steel plates, iron plates, Galvalume steel plates (registered trademark), copper plates, and enamel plates.

The barrier sheet 11, the power generation unit 10, and the sealant 12 are fixed to one surface of the building board 6. In this variation, the barrier sheet 11, the power generation unit 10, and the sealant 12 are stuck and fixed to the upper surface of the building board 6 to constitute the solar power generation device 5, as shown in Fig. 11(B). In this variation, the barrier sheet 11, the power generation unit 10, and the sealant 12 are fixed to one surface of the building board 6 by the self-adhesive force of the sealant 12.

In addition, the above-described solar power generation device 5 has the back sheet 6 that includes a building board, and can thus suppress delamination at the interfaces even if the building board is uneven.

Further, the back sheet 6 containing a metal plate can realize a solar power generation device 5 with high strength.

Note that the present invention does not limit the member constituting the installation surface 3 to the above-mentioned building materials. The installation surface 3 may alternatively be constituted by the ground (e.g., the surface of a pavement forming a road, or an inclined surface of a mountain) or a slope of a levee, or may be the surface of a structure such as an automobile, a train, or a ship. The material of the member constituting the installation surface 3 is not specifically limited either, and may be, for example, metal, hard resin, asphalt, or concrete.

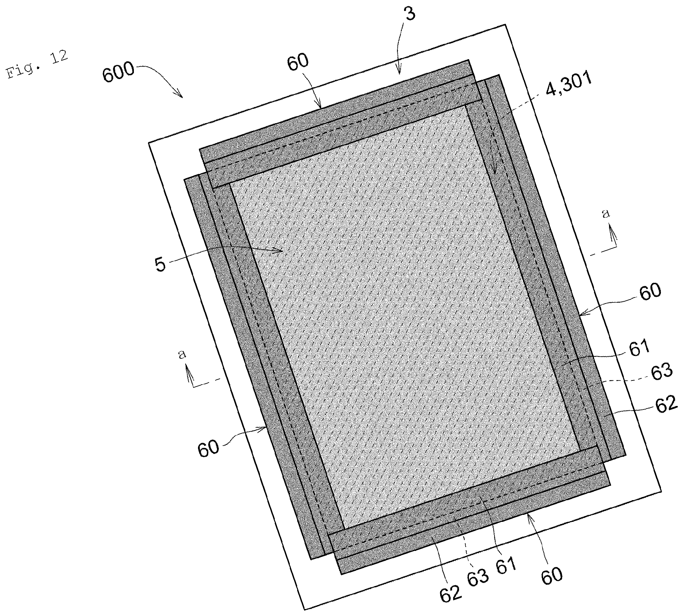

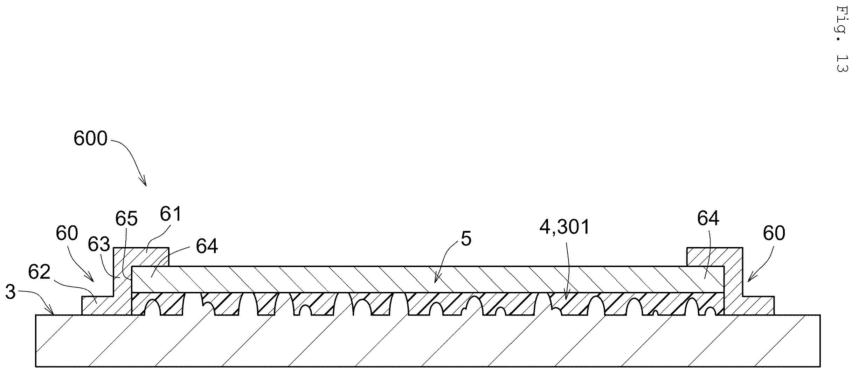

The solar power generation system of the present invention can also be varied as shown in Figs. 12 and 13. A solar power generation system 600 shown in Figs. 12 and 13 has a cover member 60 in a frame section of the solar power generation device 5. The cover member 60 has ultraviolet blocking properties, and has a width first-side section 61 and a width second-side section 62 that are bent to the opposite sides relative to a width intermediate section 63. The cover member 60 is provided such that the width first-side section 61 extends along the surface of an outer edge section 64 of the solar power generation device 5, the width intermediate section 63 extends along an outer peripheral edge 65 of the solar power generation device 5, and the width second-side section 62 extends along the installation surface 3 located outside the solar power generation device 5. Thus, the cover member 60 covers the space between the upper side of the outer edge section 64 of the solar power generation device 5, the outer peripheral edge 65 of the solar power generation device 5, and the installation surface 3. The "outer edge section of the solar power generation device" means a portion of the solar power generation device 5 having a predetermined width from the outer peripheral edge 65 of the solar power generation device 5.

According to the above-described solar power generation system 600, the cover member 60 has "a portion (equivalent to the width first-side section 61) that covers the upper side of the outer edge section 64 of the solar power generation device 5". Thus, even if a gap (not shown) occurs between the cover member 60 and the outer peripheral edge 65 of the solar power generation device 5 (i.e., even if the width intermediate section 63 of the cover member 60 is not in intimate contact with the outer peripheral edge 65), the elastic body 4 or 301 can be prevented from being irradiated with ultraviolet rays.

Although the material of the cover member 60 is not specifically limited if it has ultraviolet blocking properties, for example, a frame made of metal such as aluminum can be used as the cover member 60. If the cover member 60 is a metal frame, the cover member 60 is fixed to the installation surface 3 using bolts, an adhesive, or the like.

It is preferable to provide the cover member 60 such that the cover member 60 surrounds the entire periphery of the solar power generation device 5 as shown in Fig. 12. This can prevent degradation of the entire elastic body 4 or 301. Note that in order to surround the entire periphery of the solar power generation device 5 with the cover member 60, a linear cover member 60 may be provided on each side of the solar power generation device 5 as shown in Fig. 12, or a ring-shaped cover member 60 may be provided that surrounds the entire periphery of the solar power generation device 5. Note that the present invention does not exclude the case where the periphery of the solar power generation device 5 is not entirely surrounded by the cover member 60 (i.e., the case where the cover member 60 is provided only at a portion of the periphery of the solar power generation device 5). Even in this case, the elastic body 4 or 301 can be prevented from being irradiated with ultraviolet rays at the location where the cover member 60 is provided, thereby preventing degradation of the elastic body 4 or 301.

It is preferable that the cover member 60 presses the solar power generation device 5 moderately, and the contact pressure between the cover member 60 and the solar power generation device 5 is 0.5 MPa or greater, more preferably 1 MPa or greater, even more preferably 2.5 MPa or greater, and is 25 MPa or less, more preferably 15 MPa or less, even more preferably 10 MPa or less. The above-mentioned pressure may be measured with pressure sensitive paper or the like. By adopting the above range, it is possible to reinforce the fixation of the solar power generation device 5 and suppress flapping of the end sections of the solar power generation device 5 due to wind or the like, without hindering the deformation of the solar power generation device 5.

From the viewpoint of improving water-stopping properties from the end sections of the solar power generation device 5, continuous protrusions may be provided at a portion of the cover member 60 with which the solar power generation device 5 comes into contact. Due to the protrusions compressing areas around the solar power generation device 5, the contact pressure caused by the compression can improve the water-stopping properties of the solar power generation device 5, making it possible to keep the solar power generation device 5 in place stably for a longer period of time.

The crushing depth of the solar power generation device 5 with the protrusions is preferably 1% or greater, more preferably 5% or greater, even more preferably 10% or greater, and is 25% or less, more preferably 20% or less, even more preferably 15% or less, when the thickness of the solar power generation device 5 is 100%.

The above range improves proper water-stopping properties and does not inhibit the deformation of the solar power generation device 5.

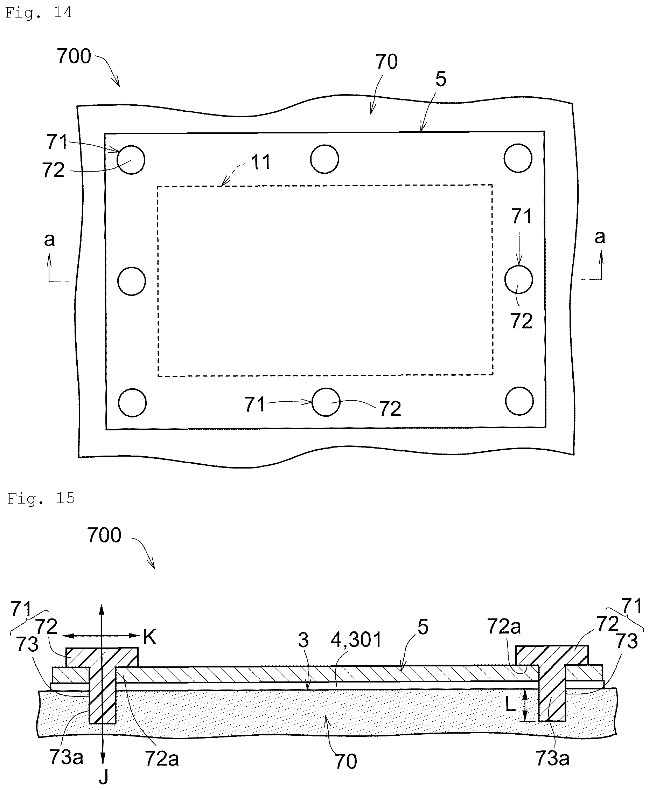

The solar power generation system of the present invention can also be varied as shown in Figs. 14 and 15. A solar power generation system 700 shown in Figs. 14 and 15 includes the installation surface 3, the elastic body 4 or 301, and the solar power generation device 5, as well as a plurality of fixing tools 71 for fixing the solar power generation device 5 to a fixation target 70 that constitutes the installation surface 3. In the following, the case where the fixation target 70 is the ground is described, but the present invention does not limit the fixation target 70 to the ground.

### Fixing tool 71

Each of the fixing tools 71 is made of resin, and includes a pressing section 72 having the pressing surface 72a that presses the solar power generation device 5 against the fixation target 70 (ground), and a buried section 73 that is integral to the pressing section 72 and has a portion 73a buried in the fixation target 70 (ground). The resin that can be used to form the fixing tool 70 is, for example, polyethylene, vinyl chloride, ABS, polypropylene, PPS, or polycarbonate.

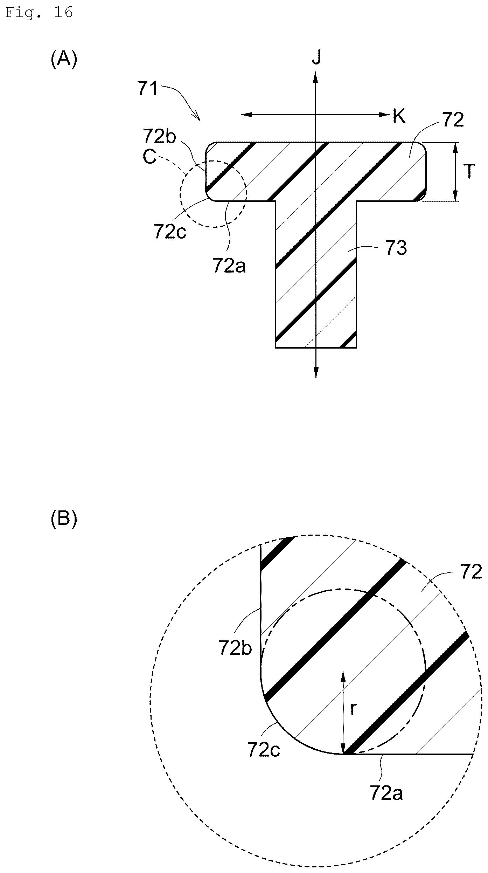

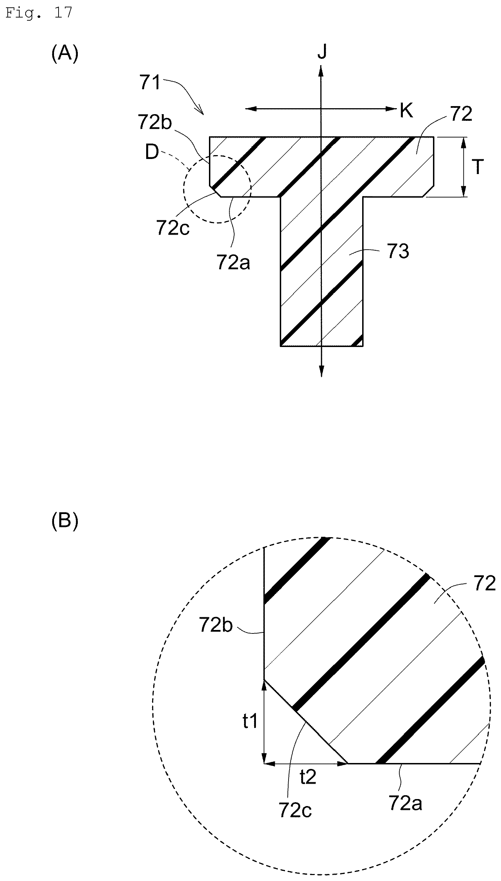

Further, from the viewpoint of suppressing damage to the solar power generation device 5 due to being pressed by the pressing section 72, it is preferable that a corner 72c between the pressing surface 72a and a side surface 72b of the pressing section 72 has a rounded shape, as shown in Figs. 16(A) and 16(B). Alternatively, from the same viewpoint, the corner 72c between the pressing surface 72a and the side surface 72b of the pressing section 72 may be chamfered, as shown in Figs. 17(A) and 17(B). In the case of adopting the above configuration, the ratio (r/T×100%) of the curvature radius r (Fig. 16(B)) of the corner 72c to a thickness T of the pressing section 72 in an extension direction J of the buried section 73, or the ratios (t1/T×100%, t2/T×100%) of chamfer widths t1 and t2 (Fig. 17(B)) in respective directions J and K to the above thickness T, are preferably 1% or greater and 100% or less, more preferably 5% or greater and 75% or less, and preferably 10% or greater and 50% or less. The chamfer width t1 means the chamfer width of the corner 72c in the extension direction J of the buried section 73, and the chamfer width t2 means the chamfer width of the corner 72c in the direction K perpendicular to the extension direction J of the buried section 73. The curvature radius r or the widths t1 and t2 of the chamfer are preferably 0.1 mm or greater and 15 mm or less, more preferably 0.5 mm or greater and 10 mm or less, even more preferably 1 mm or greater and 5 mm or less.

The fixation strength per unit area applied by the fixing tool 70 to the solar power generation device 5 can be kept small due to the pressing section 72 pressing the solar power generation device 5 with its surface (i.e., due to the pressing surface 72a of the pressing section 72 pressing the solar power generation device 5). This can suppress damage to the solar power generation device 5 due to the fixing tool 70. Note that, in order to ensure this effect, the ratio (S2/S1×100%) of an area S2 of the pressing surface 72a of each pressing section 72 to an area S1 of the upper surface of the solar power generation device 5 is 0.1% or greater, more preferably 1% or greater, even more preferably 5% or greater. Also, the ratio (ΣS2/S1×100%) of "a total ΣS2 of the areas S2 of the pressing surface 72a of all the pressing sections 72 provided in the solar power generation system 700" to the area S1 of the upper surface of the solar power generation device 5 is 5% or greater, more preferably 10%, even more preferably 20%.

Further, in order to ensure the above effect, the ratio (S2/S4×100%) of the area S2 of the pressing surface 72a of each pressing section 72 to an area S4 (S4=S1-ΣS3) obtained by subtracting a sum ΣS3 of areas S3 of the power generation units 10 of the solar power generation device 5 from the area S1 of the upper surface of the solar power generation device 5 is preferably 10% or greater, more preferably 50% or greater, even more preferably 80% or greater. Note that it is not necessary to adjust the ratio (S2/S1×100%) and the ratio (ΣS2/S1×100%) to the above values and adjust the ratio (S2/S4×100%) to the above value at the same time, and only one of those adjustments may be performed.

As a means for increasing the strength of the fixing tool 70, the material of the fixing tool 70 may be a composite reinforced material containing reinforcing fibers in resin.

The material of the reinforcing fibers contained in the above composite reinforcing material is not specifically limited, and examples thereof include glass fibers, carbon fibers, aramid fibers, and metal fibers. The fiber content is preferably 5% or greater by volume, more preferably 15% or greater, even more preferably 30% or greater. This allows the fixing tool 70 to have an appropriate strength. Meanwhile, moldability can be imparted to the fixing tool 70 by setting the content of reinforcing fibers to 80% or less by volume, more preferably 70% or less, even more preferably 60% or less. Note that the average fiber length of the reinforcing fibers is preferably 100% or less of the diameter of the pressing section 72, 71 (the maximum diameter if the diameter of the pressing section 72 changes in the extension direction J), more preferably 75% or less, more preferably 50% or less. The diameter of the pressing section 72 refers to the diameter of the cross-sectional shape of the pressing section 72 if the transverse cross-sectional shape of the pressing section 72 is circular, and refers to the diameter of a circumscribing circle of a transverse cross section of the pressing section 72 if the transverse cross-sectional shape of the pressing section 72 is not circular.

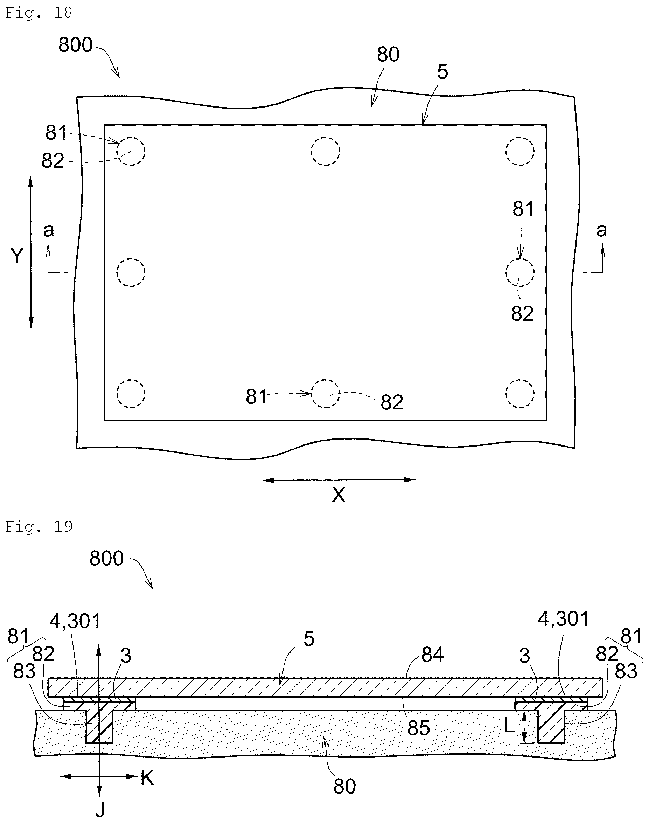

The solar power generation system of the present invention can also be varied as shown in Figs. 18 and 19. A solar power generation system 800 shown in Figs. 18 and 19 includes the installation surface 3, the elastic body 4 or 301, and the solar power generation device 5, as well as fixing tools 81 for fixing the solar power generation device 5 to a fixation target 80. In the following, the case where the fixation target 80 is the ground is described, but the present invention does not limit the fixation target 80 to the ground.

### Fixing tool 81

As shown in Fig. 19, each fixing tool 81 includes an exposed section 82 exposed from the fixation target 80, and a buried section 83 integral to the exposed section 82 and buried in the fixation target 80. The exposed section 82 constitutes the installation surface 3 and is adhered to a surface 85 of the solar power generation device 5 on the opposite side to a light-receiving surface 84, via the elastic body 4 or 301. Fig. 18 shows an example in which the fixing tools 81 are provided at four corners and the center of each side of the solar power generation device 5, but the number and positions of the fixing tools 81 are not limited to the illustrated example. Any number of fixing tools 81 can be provided at any locations as long as the solar power generation device 5 can be fixed. A plurality of fixing tools 81 may alternatively be provided at equal intervals in the long-side direction X and the width direction Y of the solar power generation device 5.

The material of the fixing tool 81 is not specifically limited, but it is preferable, for example, to use resin to form the fixing tool 81. This can suppress damage to an area around the fixing tool 81 even if the fixing tool 81 flies out. For example, polypropylene, polyvinyl chloride, or polyphenylene sulfide can be used as the resin to form the fixing tool 81. Also, fiber reinforced resin may be used to form the fixing tool 81. From the viewpoint of weather resistance, it is preferable that the color of the fixing tool 81.

### Buried section 83

The buried section 83 extends downward from the center of gravity of the exposed section 82, and is buried in the fixation target 80 (ground). The buried section 83 in the present embodiment has a circular column shape, but the shape of the buried section 83 is not specifically limited if it can be buried in the fixation target 80. For example, the buried section 83 may alternatively have a prismatic shape.

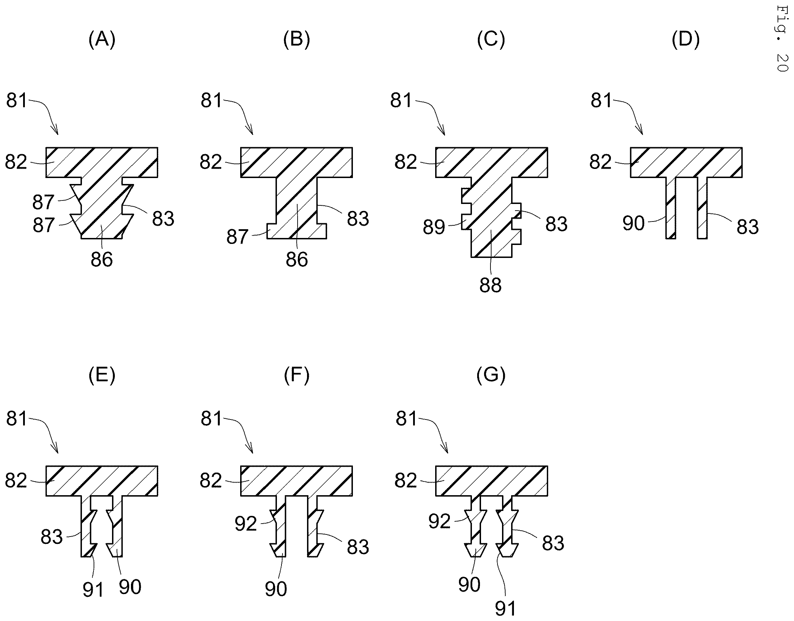

As shown in Figs. 20(A) and 20(B), the buried section 83 may also include a main body section 86 having a circular column shape or plate shape extending from the exposed section 82, and one or more protrusions 87 protruding in an annular shape from the outer surface of the main body section 86. When the buried section 83 has a plurality of protrusions 87 as shown in Fig. 20(A), the plurality of the protrusion 87 are spaced apart from each other in the long-side direction of the main body section 86. When one protrusion 87 is provided as shown in Fig. 20(B), the protrusion 87 is provided, for example, at an end section of the main body section 86 on the opposite side to the exposed section 82 (i.e., a lower end section of the main body section 86). Furthermore, when the above-mentioned protrusion(s) 87 is provided, it is preferable that the outer diameter of each protrusion 87 increases while approaching the exposed section 82 (upper side). This makes it possible to achieve both ease of insertion of the buried section 83 into the fixation target 80 and difficulty for the buried section 83 to dislodge from the fixation target 80.

Alternatively, the buried section 83 may have a main body section 88 having a circular column shape extending from the exposed section 82, and a helical screw section 89 formed on the outer surface of the main body section 88, as shown in Fig. 20(C). In this case, the buried section 83 is buried into the fixation target 80 by screwing the buried section 83 with the fixation target 3.

Alternatively, the buried section 83 may have a tubular main body section 90 extending from the exposed section 82, as shown in Figs. 20(D), 20(E), 20(F) and 20(G). This makes it possible to secure a large area in which the buried section 83 comes into contact with the fixation target 80, and can thus increase the force fixing the solar power generation device 5 to the fixation target 80 with the fixing tools 81.

Alternatively, the buried section 83 may further has one or more protrusions 91 protruding in an annular shape from the inner surface of the main body section 90, as shown in Fig. 20(E). Alternatively, the buried section 83 may have one or more protrusions 92 protruding in an annular shape from the outer surface of the main body section 90, as shown in Fig. 20(F). Alternatively, the buried section 83 may have one or more protrusions 91 and 92 protruding in an annular shape from the inner and outer surfaces of the main body section 90, respectively, as shown in Fig. 20(G). The above configurations can further increase the force fixing the solar power generation device 5 with the fixing tools 81.

When the protrusions 91 are provided on the inner surface of the main body section 90 (Figs. 20(E) and 20(G)), it is preferable to provide the protrusions 91 such that the inner diameter of each protrusion 91 decreases toward the exposed section 82 (upper side) . When the protrusions 92 are provided on the outer surface of the main body section 90 (Figs. 20(F) and 20(G)), it is preferable to provide the protrusions 92 such that the outer diameter of each protrusion 92 increases toward the exposed section 82 (upper side) .

The length L of the buried section 83 is not specifically limited, but is preferably 10 mm or greater, more preferably 25 mm or greater, even more preferably 100 mm or greater. Also, the length L of the buried section 83 is preferably 500 mm or less, more preferably 200 mm or less.

A portion of the buried section 83 that extends from the exposed section 82 may be formed such that its diameter does not change in the extension direction J, or may be formed such that its diameter gradually changes in the extension direction J (e.g., may be formed such that its lower end is tapered). The "portion of the buried section 83 that extends from the exposed section 82" corresponds to the entire buried section 83 in the example of Fig. 19, and the main body sections 86, 88, and 90 in the examples of Figs. 20(A), 20(B), 20(C), 20(D), 20(E), 20(F), and 20(G). If the "portion of the buried section 83 that extends from the exposed section 82" has a circular column shape or a cylindrical shape, the above-mentioned diameter refers to the diameter or outer diameter thereof. If the "portion of the buried section 83 that extends from the exposed section 82" does not have a circular column shape or a cylindrical shape, the above-mentioned diameter refers to the diameter of a circumscribing circle of a transverse cross section of the "portion of the buried section 83 that extends from the exposed section 82". The transverse cross section means a cross section of the buried section 83 taken along the direction K perpendicular to the extension direction J thereof.

The diameter of the portion of the buried section 83 that extends from the exposed section 82 is not specifically limited, but is preferably 10 mm or greater, more preferably 15 mm or greater. Also, the diameter of the portion of the buried section 83 that extends from the exposed section 82 is preferably 200 mm or less, more preferably 150 mm or less. If the transverse cross section of the buried section 83 changes in the extension direction J, the diameter means the maximum diameter of the "portion of the buried section 83 that extends from the exposed section 82".

### Exposed section 82

The exposed section 82 is adhered via the elastic body 4 to the lower surface of the back sheet 10 forming the surface 85 of the solar power generation device 5. The diameter of the lower end of the exposed section 82 is larger than the diameter of the above-mentioned "portion of the buried section 83 that extends from the buried section 82".

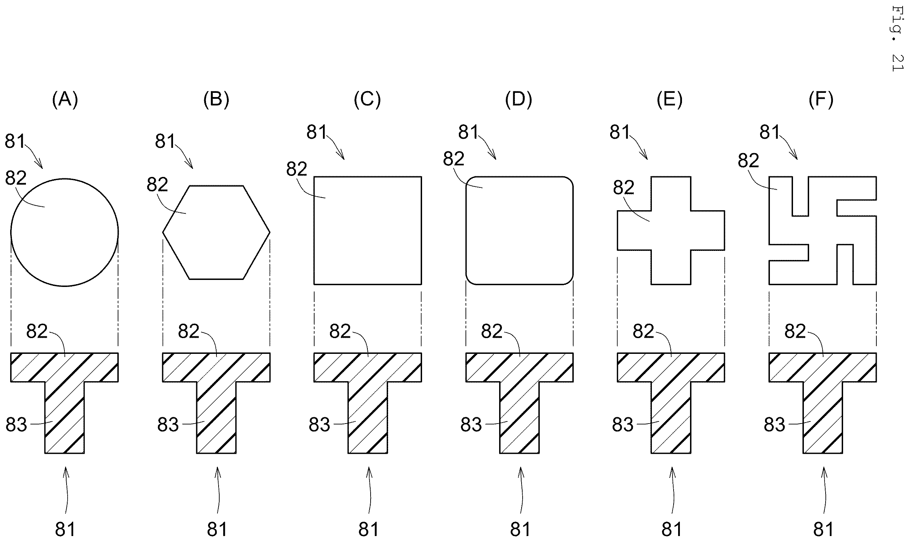

In the illustrated example, the transverse cross-sectional shape of the exposed section 82 has a circular shape (Figs. 18 and 21(A)), but the transverse cross-sectional shape of the exposed section 82 is not specifically limited if the exposed section 82 can be adhered to the solar power generation device 5 using the elastic body 4. For example, the transverse cross-sectional shape of the exposed section 82 may alternatively be hexagonal (Fig. 21(B)), rectangular with sharp corners (Fig. 21(C)), rectangular with rounded corners (Fig. 21(D)), cross-shaped (Fig. 21(E)), or swastika-shaped (Fig. 21(F)). Note that the transverse cross-sectional shape of the exposed section 82 means the shape of a cross section of the exposed section 82 taken along the direction K perpendicular to the extension direction J of the buried section 83.

The diameter at the upper end of the exposed section 82 that is adhered to the surface 85 of the solar power generation device 5 is not specifically limited, but is preferably 30 mm or greater, more preferably 50 mm or greater, from the viewpoint of widely and firmly adhering the surface 85 of the solar power generation device 5 to the exposed section 82. Further, the diameter at the upper end of the exposed section 82 is preferably 500 mm or less, more preferably 200 mm or less. Note that, when the shape of the transverse cross section (i.e., the upper surface of the exposed section 82) is circular, the above-mentioned "diameter at the upper end of the exposed section 82" refers to the diameter of that transverse cross section of the upper end. When the transverse cross section at the upper end of the exposed section 82 (i.e., the upper surface of the exposed section 82) is not circular, the "diameter at the upper end of the exposed section 82" refers to the diameter of a circumscribing circle of that transverse cross section.

The area of the transverse cross section at the upper end of the exposed section 82 (i.e., the upper surface of the exposed section 82) is not specifically limited, but is preferably 650 mm2 or greater, more preferably 2000 mm2 or greater. Also, the area of the transverse cross section at the upper end of the exposed section 82 (i.e., the upper surface of the exposed section 82) is not specifically limited, but is preferably 200,000 mm2 or less, more preferably 20,000 mm2 or less.

The ratio between the "diameter at the upper end of the exposed section 82" and the "diameter of the portion of the buried section 83 that extends from the exposed section 82 (the maximum diameter if the diameter of the buried section 83 changes in the extension direction J)" is not specifically limited. However, in order to widely and firmly adhere the surface 85 of the solar power generation device 5 to the exposed section 82, the "diameter at the upper end of the exposed section 82" is preferably 1.1 times or greater the "diameter of the portion of the buried section 83 that extends from the exposed section 82", more preferably 1.8 times or greater. Further, the "diameter at the upper end of the exposed section 82" is preferably 2.5 times or less the "diameter of the portion of the buried section 83 that extends from the pressing section 82".

In order to maintain stable adhesion between the solar power generation device 5 and the exposed section 82, the ratio (S2/S1×100%) of the area S2 of the transverse cross section at the upper end of each exposed section 82 (i.e., the upper surface of each exposed section 82) to the area S1 of the surface 85 of the solar power generation device 5 is preferably 0.1% or greater, more preferably 1% or greater, even more preferably 5% or greater. Also, the ratio (ΣS2/S1×100%) of the "total ΣS2 of the areas S2 of the transverse cross sections at the upper ends of all the exposed sections 82 provided in a fixing structure 2" to the area S1 of the surface 85 of the solar power generation device 5 is preferably 5% or greater, more preferably 10%, even more preferably 20%.

Further, in order to maintain stable adhesion between the solar power generation device 5 and the exposed section 82, the ratio (S2/S4×100 %) of the area S2 of the transverse cross section at the upper end of each exposed section 82 (i.e., the upper surface of each exposed section 82) to the area S4 (S4=S1-ΣS3) obtained by subtracting the sum ΣS3 of the areas S3 of the power generation units 10 of the solar power generation device 5 from the area S1 of the surface 85 of the solar power generation device 5 is preferably 10% or greater, more preferably 50% or greater, even more preferably 80% or greater. Note that it is not necessary to adjust the ratio (S2/S1×100%) and the ratio (ΣS2/S1×100%) to the above values and adjust the ratio (S2/S4×100%) to the above value at the same time, and only one of those adjustments may be performed.

### Operation and effect

According to the present embodiment, the exposed section 82 of the fixing tool 81 is adhered to the surface 85 of the solar power generation device 5 on the opposite side to the light-receiving surface 84, so that the fixing tool 81 does not block light traveling toward the light-receiving surface 84 of the solar power generation device 5. Therefore, it is possible to prevent a decrease in the amount of electric power generated by the solar power generation device 5 due to the fixing tool 81.

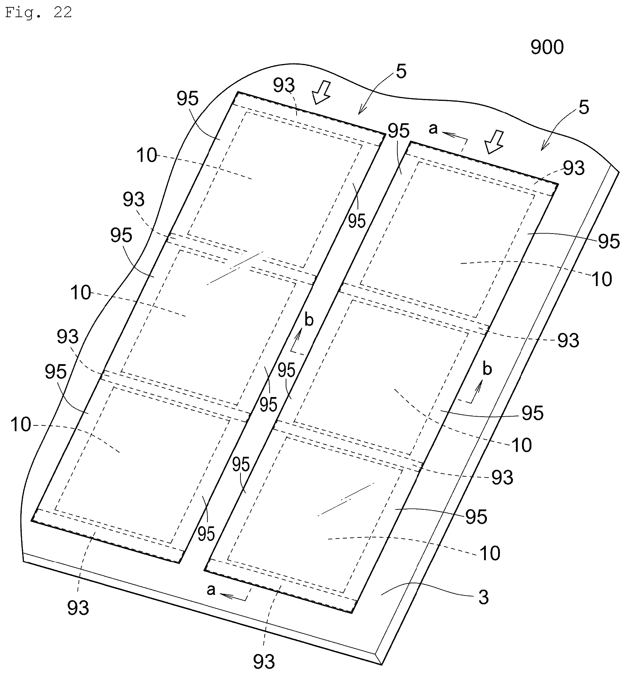

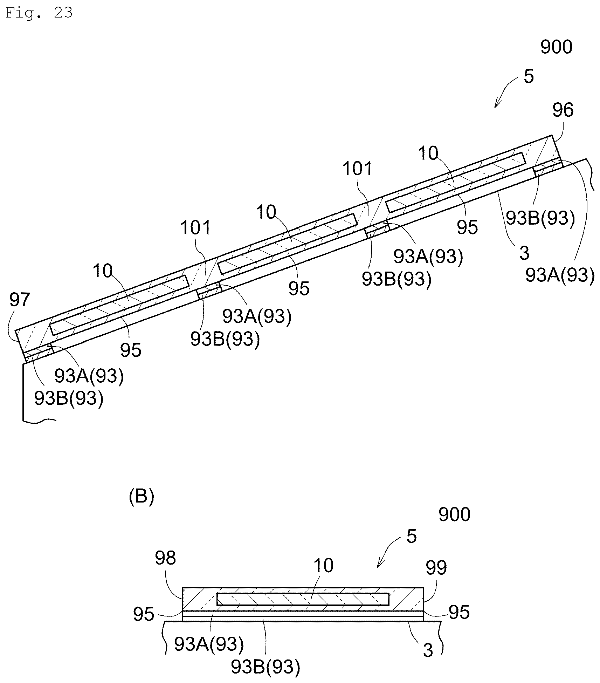

The solar power generation system of the present invention can also be varied as shown in Figs. 22 and 23. A solar power generation system 900 shown in Figs. 22 and 23 includes the installation surface 3, elastic bodies 93, and the solar power generation device 5. The elastic bodies 93 are fixed in a state placed on the installation surface 3, and a back sheet constituting a bottom section of the solar power generation device 5 is fixed in a state placed on the upper surfaces of the elastic bodies 93.

### Elastic body

As shown in Figs. 22 and 23, fixing materials 93 are located in areas avoiding the power generation units 10, and fix the solar power generation devices 5 to the installation surface 3 in an attachable and detachable manner. In the present embodiment, the fixing materials 93 extend between the solar power generation device 5 and the installation surface 3 along one direction of the solar power generation device 5, and are spaced apart from each other in the other direction perpendicular to the one direction.

In the illustrated example, the fixing materials 93 extend between the solar power generation device 5 and the installation surface 3 along the short-side direction of the solar power generation device 5, which is rectangular in a plan view, and are spaced apart from each other in the long-side direction. The fixing materials 93 fix portions of the solar power generation device 5 to the installation surface 3. The fixing materials 93 do not fix the solar power generation device 5 to the installation surface 3 over its entire area, nor over its entire periphery. Thus, the solar power generation device 5 includes, within its peripheral section, a non-fixed area 94 that is not fixed to the installation surface 3, and also includes, in the peripheral section, a non-fixed area 95 that is not fixed to the installation surface 3.

Note that the peripheral section means an area having a certain range from the periphery (four sides 96 to 99 in the present embodiment) that forms the outline of the solar power generation device 5. The non-fixed areas refer to areas of the solar power generation device 5 that are not restricted from moving away from the installation surface 3 by any member. A gap may occur between the solar power generation device 5 and the installation surface 3 in the non-fixed areas 95 and 94, while this gap is approximately 1 mm or greater and 5 mm or less.

The elastic body 93 has a transverse elastic coefficient of preferably 10 MPa or greater and 100 MPa or less, more preferably 0.1 MPa or greater and 10 MPa or less. Alternatively, the elastic body 4 has a viscosity of preferably 0.1 Pa·s or greater and 10000 Pa·s or less, more preferably 1 Pa·s or greater and 1000 Pa·s or less. Examples of the elastic body 93 include a hook-and-loop fastener such as Velcro (registered trademark), double-sided tape, a magnet, and an adhesive. One or a combination of two or more of them can be selected and used as the elastic body 93. When the elastic body 93 is made of a composite material such as a magnet or double-sided tape, the above-mentioned transverse elastic coefficient is measured by conducting a test in which the entire elastic body 93 is pulled in a direction along the installation surface 3. When the elastic body has a composite material, the above-mentioned viscosity is measured by a method of measuring the viscosity between layers, such as shear measurement.

The solar power generation system 900 is characterized in that a plurality of power generation units 10 are spaced apart from each in the long-side direction, which is the other direction of the solar power generation device 5, and the elastic bodies 93 are spaced apart from each other in the long-side direction that is the other direction of the solar power generation device 5, while sandwiching the respective power generation units 10. Thus, it is possible to suppress vibration of the solar power generation device 5 due to the influence of wind or the like when installed on the installation surface 3. It is possible to suppress a decrease in the power generation efficiency due to the vibration of the installed solar power generation device 5.

Note that each elastic body 93 is not limited to being the above-mentioned hook-and-loop fastener, double-sided tape, magnets, or an adhesive, if the elastic body 93 allows the solar power generation device 5 to be easily fixed to the installation surface 3 and to be easily peeled off from the installation surface 3 when recovering the solar power generation device 5.

In the illustrated example, each elastic body 93 is constituted by two band-shaped hook-and-loop fasteners 93A and 93B that are attachable to and detachable from each other and each have a predetermined width and length. The hook-and-loop fasteners 93A and 93B each have a transverse elastic coefficient of preferably 10 MPa or greater and 100 MPa or less, more preferably 0.1 MPa or greater and 10 MPa or less. Alternatively, the hook-and-loop fasteners 93A and 93B has a viscosity of preferably 0.1 Pa·s or greater and 10000 Pa·s or less, more preferably 1 Pa·s or greater and 1000 Pa·s or less. One hook-and-loop fastener 93A is stuck to the surface of the solar power generation device 5 that faces the installation surface 3 using, for example, an adhesive, a pressure-sensitive adhesive, double-sided tape, or the like, and the other hook-and-loop fastener 93A is stuck to the installation surface 3 using, for example, an adhesive, a pressure-sensitive adhesive, double-sided tape, or the like.

Although the material of the hook-and-loop fasteners 93A and 93B are not specifically limited, examples thereof include nylon, polyester, and polypropylene. Among them, polypropylene is preferable from the viewpoint of durability. Specific examples of the hook-and-loop fasteners 93A and 93B include TMSD-25 manufactured by TRSUCO and the like.

The hook-and-loop fasteners 93A are not specifically limited, but preferably extend along two opposing sides of the solar power generation device 5. In the present embodiment, the hook-and-loop fasteners 93A extend along the two short sides 96 and 97 of the solar power generation device 5. The hook-and-loop fasteners 93A may abut against the two respective short sides 96 and 97 of the solar power generation device 5; that is, there may be no gap between the hook-and-loop fasteners 93A and the two respective short sides 96 and 97. Alternatively, the hook-and-loop fasteners 93A may be located close to the two respective short sides 96 and 97 of the solar power generation device 5; that is, there may be gaps between the hook-and-loop fasteners 93A and the two respective short sides 96 and 97.

Furthermore, one hook-and-loop fastener 93A or a plurality of hook-and-loop fasteners 93A spaced apart from each other are provided between the two short sides 96 and 97 of the solar power generation device 5 so as to extend parallel with the two short sides 96 and 97. These hook-and-loop fasteners 93A are not specifically limited. However, from the viewpoint of firmly fixing the solar power generation device 5 to the installation surface 3, it is preferable that the hook-and-loop fasteners 93A extend continuously and uninterrupted between the other pair of opposing sides (between two long sides 98 and 99 in the illustrated example) of the solar power generation device 5 over their entire length or almost entire length.

Note that "parallel" means "substantially parallel," and includes not only cases where target straight lines or surfaces do not intersect when extended, but also cases where the target lines or surfaces intersect within a range of 10° when extended.

The at least one hook-and-loop fastener 93A provided between the two short sides 96 and 97 of the solar power generation device 5 is not specifically limited, but is located in an area avoiding the power generation units 10 (an area that does not overlap with the power generation units 10 in a plan view). For example, the hook-and-loop fastener 93A is provided in an area 101 (hereinafter referred to as a "cell boundary section 101") between adjacent power generation units 10. In this case, from the viewpoint of firmly fixing the solar power generation device 5 to the installation surface 3, it is preferable that the hook-and-loop fasteners 93A are provided at all boundary sections 101. That is, it is preferable that the hook-and-loop fasteners 93A are spaced apart from each other in the long-side direction of the solar power generation device 5 so as to sandwich the respective power generation units 10 from two opposite sides. Note that it is not necessary to provide the hook-and-loop fasteners 93A at all the cell boundary sections 101.

Due to the above-described arrangement of the hook-and-loop fasteners 93A, the areas of the solar power generation device 5 within the peripheral section where the power generation units 10 are located (the area overlapping with the power generation units 10 in a plan view) are areas where the hook-and-loop fasteners 93A are not provided, and these areas each serve as the non-fixed area 94 that is not fixed to the installation surface 3. Further, the areas of the solar power generation device 5 that extend along the two long sides 98 and 99 of the peripheral section and adjacent to the power generation unit 10 are areas where the hook-and-loop fasteners 93A are not provided, and these area each serve as the non-fixed area 95 that is not fixed to the installation surface 3.

The width of each hook-and-loop fastener 93A as the elastic body 93 is not specifically limited, but is preferably 10 mm or greater and 50 mm or less, more preferably 15 mm or greater and 30 mm or less. The width of each hook-and-loop fastener 93A being within the above-mentioned numerical range allows the solar power generation device 5 to be favorably fixed to the installation surface 3, and allows the solar power generation device 5 to be easily peeled off from the installation surface 3 without difficulty when recovering the solar power generation device 5. Moreover, it is possible to prevent the hook-and-loop fasteners 93A from extending into areas of the solar power generation device 5 where the power generation units 10 are located and being fixed to the installation surface 3.

### Construction method of solar power generation device

Next, an example of a construction method for installing the solar power generation device 5 according to the present embodiment on the installation surface 3 will be described.

First, a worker sticks the hook-and-loop fasteners 93B, which are attachable to and detachable from the hook-and-loop fasteners 93A provided as the elastic body 93 on the solar power generation device 5, to the location on the installation surface 3 where the solar power generation device 5 is to be placed, at positions corresponding to the hook-and-loop fasteners 93A using an adhesive, a pressure-sensitive adhesive, double-sided tape, or the like.

Then, the worker places the solar power generation device 5 on the installation surface 3, and adheres the hook-and-loop fasteners 93A, which are spaced apart from each other in the long-side direction of the solar power generation device 5, to the corresponding hook-and-loop fasteners 93B on the installation surface 3, sequentially from the hook-and-loop fastener 93A located at one end in the long-side direction (the side corresponding to the short side of one of the two short sides 96 and 97). Thus, the solar power generation device 5, which is rectangular in a plan view, is fixed to the installation surface 3 using the elastic bodies 93 extending along the short-side direction (one direction out of the longitudinal and lateral directions) of the solar power generation device 5, in a plurality of areas spaced apart from each other in the long-side direction (the other direction out of the longitudinal and lateral directions) and avoiding the power generation units 10 of the solar power generation device 5. The construction of the solar power generation device 5 is thus completed. According to this method, the flexible solar power generation device 5 can be easily installed on the installation surface 3.

### Method of peeling off solar power generation device

Next, an example of a method for peeling off the solar power generation device 5 from the installation surface 3 according to the present embodiment will be described.

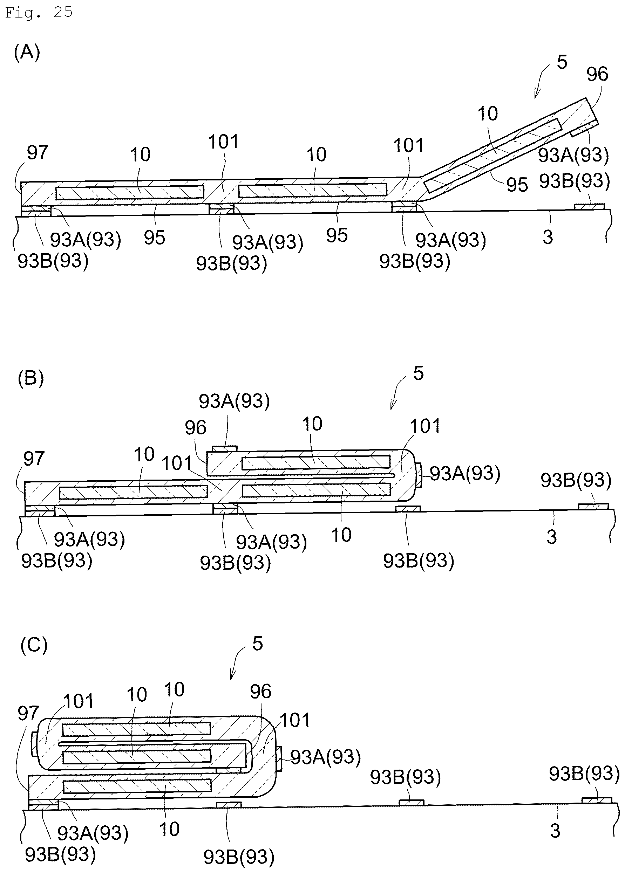

When recovering the solar power generation device 5, the solar power generation device 5 is peeled off from the installation surface 3, not in the short-side direction in which the elastic bodies 93 extend but in the long-side direction (the direction indicated by the arrows in Fig. 22) that intersects with the short-side direction in which the installation surface 93 extends, as shown in Figs. 22 and 25.

Specifically, regarding the elastic bodies 93 spaced apart from each other in the long-side direction of the solar power generation device 5, first, the fixation of the solar power generation device 5 and the installation surface 3 with the elastic body 93 located at one end in the long-side direction (closer to one short side 96 out of the two short sides 96 and 97) is released; that is, the hook-and-loop fastener 93A on the solar power generation device 5 side is removed from the hook-and-loop fastener 93B on the installation surface 3 side, as shown in Fig. 25(A). This allows non-fixed areas 15 and 16 of the solar power generation device 5 that are adjacent to the unfixed elastic body 93 to be easily peeled off from the installation surface 3. The area of the solar power generation device 5 that has been peeled off from the installation surface 3 is folded over to the opposite side at a cell boundary section 14 where the elastic body 93 located next in the long-side direction is located.

Next, as shown in Fig. 25(B), the fixation of the solar power generation device 5 and the installation surface 3 with the elastic body 93 located next in the long-side direction, is released; that is, the hook-and-loop fastener 93A on the solar power generation device 5 side is removed from the hook-and-loop fastener 93B on the installation surface 3 side. This allows non-fixed areas 15 and 16 of the solar power generation device 5 that are adjacent to the unfixed elastic body 93 to be easily peeled off from the installation surface 3. The area of the solar power generation device 5 that has been peeled off from the installation surface 3 is folded over to the opposite side at a cell boundary section 14 where the elastic body 93 located next in the long-side direction is located.

Lastly, as shown in Fig. 25(C), the fixation of the solar power generation device 5 and the installation surface 3 with the elastic body 93 located at the other end in the long-side direction (the end closer to the other short side 97 out of the two short sides 96 and 97) is released; that is, the hook-and-loop fastener 93A on the solar power generation device 5 side is removed from the hook-and-loop fastener 93B on the installation surface 3 side. This allows the entire solar power generation device 5 to be peeled off from the installation surface 3 and recovered.

According to this method, when the solar power generation device 5 is peeled off from the installation surface 3, the power generation units 10 do not bend, and stress is not concentrated on the power generation units 10. The solar power generation device 5 can thus be easily peeled off from the installation surface 3 while suppressing damage to the power generation units 10. In addition, the solar power generation device 5 can be peeled off from the installation surface 3 while being folded compactly. Thus, even in a windy environment such as on a roof, the solar power generation device 5 can be prevented from being blown away by the wind and easily peeled off from the installation surface 3.

Alternatively, the area (the non-fixed area 95 in the above embodiment) in the peripheral section of the solar power generation device 5 that is not fixed to the installation surface 3 with the elastic body 93, as well as the area (the non-fixed area 94 in the above embodiment) where the power generation unit 10 is located within the peripheral section of the solar power generation device 5 may be fixed to the installation surface 3 with a weak elastic body 102, as shown in Fig. 25(B).

The weak elastic body 102 may be at least one selected from a group consisting of a hook-and-loop fastener, a magnet, double-sided tape, and an adhesive. The fixation strength of the weak elastic body 102 is preferably 3/4 or less, more preferably 2/3 or less, more preferably 1/2 or less of the fixation strength of the elastic body 93.

As used herein, the fixation strengths of the elastic body 93 and the weak elastic body 102 mainly refer to the peel force, which is preferably measured by a 90-degree peel test (JIS Z0237). The measurement method and peeling speed are measured under the same conditions when making the above-mentioned relative comparison.

The means for making the fixation strength of the elastic body 93 and the fixation strength of the weak fixing material 102 different is not specifically limited. If the elastic body 93 and the weak fixing material 102 are hook-and-loop fasteners, examples of the means include making a difference in the adhesive strength therebetween, or making a difference in the width of the hook-and-loop fasteners. If the elastic body 93 and the weak fixing material 102 are magnets, examples of the means include making a difference in the magnetic force or in the width of the magnets. If the elastic body 93 and the weak fixing material 102 are double-sided tape or adhesives, examples of the means include making a difference in the adhesive strength, or making a difference in the width of the application area of the double-sided tape or the adhesives.

In the embodiment shown in Fig. 25, if the fixation strength of the weak fixing material 102 is, for example, half or less of the fixation strength of the elastic body 93, the solar power generation device 5 can be peeled off from the installation surface 3 as described below. That is, when the solar power generation device 5 is gradually peeled off from the installation surface 3, the solar power generation device 5 is peeled off from the installation surface 3 as described in the above embodiment if the fixation of the solar power generation device 5 and the installation surface 3 with the weak fixing material 102 is easily released while the solar power generation device 5 is peeled off; that is, if the solar power generation device 5 can be peeled off from the installation surface 3 without difficulty such that the power generation units 10 are not bent.

In the embodiment shown in Fig. 25, if the fixation strength of the weak fixing material 102 is, for example, half or less of the fixation strength of the elastic body 93, the solar power generation device 5 can be peeled off from the installation surface 3 as described below. That is, when the solar power generation device 5 is gradually peeled off from the installation surface 3, if the fixation of the solar power generation device 5 and the installation surface 3 with the weak fixing material 102 is difficult to release while the solar power generation device 5 is peeled off, and the power generation units 10 are bent, the area of the solar power generation device 5 that is fixed to the installation surface 3 with the weak fixing material 102 is first peeled off from the installation surface 3. Then, the solar power generation device 5 is peeled off from the installation surface 3 as in the above embodiment.

This allows the solar power generation device 5 to be favorably fixed to the installation surface 3 while preventing the solar power generation device 5 in the installed state from peeling off from the installation surface 3, and also allows the solar power generation device 5 to be easily peeled off from the installation surface 3 when recovering the solar power generation device 5.

In all of the above embodiments, the solar power generation device 5 includes a plurality of power generation units 10 arranged in a line in the long-side direction. As a solar power generation system 900 in another embodiment, the solar power generation device 5 may alternatively have a plurality of rows in the short-side direction of a plurality of power generation units 10 arranged in the long-side direction, as shown in Fig. 8.

The present disclosure includes the following items.

One aspect of a conventional solar power generation device is a flexible solar cell module that includes a metal plate, a fluorine resin sheet, a photoelectric conversion layer located between the metal plate and the fluorine resin sheet, and an adhesive layer filled between the metal plate and the fluorine resin sheet. The flexible solar cell module has flexibility.

A flexible solar cell module such as the above one has flexibility, and is therefore partially bent and used depending on the location where it is installed in some cases.

However, if a portion of the flexible solar cell module is bent, there is a concern that delamination may occur at at least either the interface between the adhesive layer and the metal plate or the interface between the adhesive layer and the fluorine resin sheet.

That is, if a portion of the flexible solar cell module is bent, the fluorine resin sheet and the metal plate may deform at the bent portion, causing one to stretch and the other to contract. At this time, the adhesive layer, which is fixed to the fluorine resin sheet and the metal plate, not only follows the bending of both of them, but also elastically deforms as a result of also following the stretch and contraction, while residual stress may occur in the adhesive layer. Thus, with the conventional flexible solar cell module, there is a concern that delamination may occur at the interface between adjacent layers (hereinafter referred to as an "inter-layer interface" in some cases) after long-term use if the product is used in a use mode other than in a flat state.

Another object of the present invention is to provide a solar power generation device capable of suppressing delamination occurring at an inter-layer interface after long-term use, even in use modes other than a flat mode.

To achieve the above object, the present invention embraces a solar power generation device according to the following item 1.

Item 1. A solar power generation device including:
a back sheet;
a barrier sheet provided at an interval from the back sheet and having translucency;
a power generation unit located between the back sheet and the barrier sheet; and
a sealant filled between the back sheet and the barrier sheet and covering at least a portion of the power generation unit,
the sealant having a transverse elastic coefficient of 400 MPa or less.

The solar power generation device according to item 1 preferably embraces an aspect according to the following item 2.

Item 2. A solar power generation device including:
a back sheet;
a barrier sheet provided at an interval from the back sheet and having translucency;
a power generation unit located between the back sheet and the barrier sheet; and
a sealant filled between the back sheet and the barrier sheet and covering at least a portion of the power generation unit,
the sealant having a viscosity of 11000 mPa·S or greater and 700000 mPa·S or less.

The solar power generation device according to item 1 or 2 preferably embraces an aspect according to the following item 3.

Item 3. The solar power generation device according to item 1 or 2, wherein the back sheet has a delamination strength of 0.1 N/mm or greater against the sealant.

The solar power generation device according to any one of items 1 to 3 preferably embraces an aspect according to the following item 4.

Item 4. The solar power generation device according to any one of items 1 to 3, wherein the barrier sheet has a delamination strength of 0.1 N/mm or less against the sealant.

The solar power generation device according to any one of items 1 to 4 preferably embraces an aspect according to the following item 5.

Item 5. The solar power generation device according to any one of items 1 to 4, further comprising:
at least one bent section,
wherein the bent section forms an angle of 150° or greater and less than 180°.

The solar power generation device according to any one of items 1 to 5 preferably embraces an aspect according to the following item 6.

Item 6. The solar power generation device according to any one of items 1 to 5, wherein a ratio of a linear expansion coefficient of the barrier sheet to that of the back sheet is 6.0 or less.

The solar power generation device according to any one of items 1 to 6 preferably embraces an aspect according to the following item 7.

Item 7. The solar power generation device according to any one of items 1 to 6, wherein the back sheet includes a metal plate.

The solar power generation device according to any one of items 1 to 7 embraces an aspect according to the following item 8.

Item 8. The solar power generation device according to any one of items 1 to 7, wherein the back sheet includes a building board.

The solar power generation device according to the above aspects has the advantage that delamination at an inter-layer interface due to long-term use can be suppressed even in use modes other than a flat mode.

A frame surrounding the solar power generation device is conventionally fastened to a support material using metal fittings to fix the solar power generation device.

If the frame appears on the light-receiving surface side of the solar power generation device, a problem may arise in that the frame blocks light traveling toward the light-receiving surface, resulting in a decrease in the amount of electric power generated by the solar power generation device.

Another object of the present invention is to provide a fixing structure for a solar power generation device capable of preventing the fixing tool from reducing the amount of electric power generated by the solar power generation device since the fixing tool does not block light traveling toward the light-receiving surface of the solar power generation device.

To achieve the above object, the present invention embraces the subject matter described in the following item.

Item 1. A fixing structure for a solar power generation device comprising:
a solar power generation device configured to generate electric power in response to light incident from a light-receiving surface thereof: and
one or more fixing tools for fixing the solar power generation device to a fixation target,
each of the fixing tools including: an exposed section exposed from the fixation target; and at least one buried section integral to the exposed section and buried in the fixation target,
the exposed section and a surface of the solar power generation device on an opposite side to the light-receiving surface being adhered to each other via an adhesive layer.

The fixing structure for a solar power generation device according to item 1 preferably embraces an aspect according to the following item 2.

Item 2. The fixing structure for a solar power generation device according to item 1,
wherein the power generation sheet has flexibility, and the power generation sheet has a bending strength of 10 MPa or greater and 150 MPa or less.

The fixing structure for a solar power generation device according to item 1 or 2 preferably embraces an aspect according to the following item 3.

Item 3. The fixing structure for a solar power generation device according to item 1 or 2, wherein the fixing tools are made of resin.

The fixing structure for a solar power generation device according to items 1 to 3 preferably embraces an aspect according to the following item 4.

Item 4. The fixing structure for a solar power generation device according to any one of items 1 to 3, wherein the adhesive layer is made of a resin composition containing at least one selected from: vinyl acetate resin; ethylene vinyl acetate resin; epoxy resin; cyanoacrylate resin; acrylic resin; chloroprene rubber: styrene; butadiene rubber; polyurethane resin; silicone resin; and modified silicone resin.

According to the above aspects, the exposed section is adhered to the surface of the solar power generation device on the opposite side to the light-receiving surface, so that the fixing tools do not block light traveling toward the light-receiving surface of the solar power generation device. It is therefore possible to prevent a decrease in the amount of electric power generated by the solar power generation device due to the fixing tool.

### Description of Reference Numerals

1,201,302 Laminated body
3 Fiber-containing sheet
4,93,301 Elastic body
5 Solar power generation device
6 Back sheet
100, 200, 300, 400, 500, 600, 700, 800, 900 Solar power generation system

## Claims

1. A laminated body comprising:
an installation surface; an elastic body; and a back sheet constituting a bottom section of a solar power generation device, the elastic body being fixed in a state placed on the installation surface, and the back sheet being fixed in a state placed on an upper surface of the elastic body.

2. The laminated body according to claim 1, wherein the elastic body has a longitudinal elastic modulus of 0.1 MPa or greater and 1000 MPa or less.

3. The laminated body according to claim 1, wherein a ratio (Eb/Ea) between a transverse elastic modulus Ea of the back sheet and a transverse elastic modulus Eb of the elastic body is 0.002 or greater and 0.05 or less.

4. The laminated body according to claim 1, wherein the elastic body has a transverse elastic modulus of 0.1 MPa or greater and 100 MPa or less.

5. The laminated body according to claim 1,
wherein the installation surface is constituted by a fiber-containing sheet, and a shear peel strength of the fiber-containing sheet and the back sheet via the elastic body is 0.1 N/cm or greater.

6. The laminated body according to claim 1,
wherein the installation surface is constituted by a fiber-containing sheet, and the elastic body has a linear expansion coefficient greater than a linear expansion coefficient of the fiber-containing sheet and smaller than a linear expansion coefficient of the back sheet.

7. The laminated body according to claim 1,
wherein the solar power generation device includes: the back sheet; a power generation unit; a barrier sheet; and a sealant, the barrier sheet is located on an opposite side to the back sheet in a thickness direction of the solar power generation device, the power generation unit includes a power generation cell being a photoelectric conversion element utilizing a photovoltaic effect and is located between the back sheet and the barrier sheet, the sealant fills a space surrounding the power generation unit between the barrier sheet and the back sheet, and the sealant has a transverse elastic modulus of 0.01 or greater and 500 MPa or less.

8. A solar power generation system comprising:
an installation surface; an elastic body; and a solar power generation device, the elastic body being fixed in a state placed on the installation surface, and a back sheet constituting a bottom section of the solar power generation device being fixed in a state placed on an upper surface of the elastic body.
